(19) Europäisches Patentamt / European Patent Office / Office européen des brevets

(11) **EP 4 478 068 A1**

(12) **EUROPEAN PATENT APPLICATION**
published in accordance with Art. 153(4) EPC

(43) Date of publication:
18.12.2024 Bulletin 2024/51

(21) Application number: 22924916.4

(22) Date of filing: 26.09.2022

(51) International Patent Classification (IPC):
$G01R\ 31/392$ (2019.01)   $G01R\ 31/367$ (2019.01)
$G01R\ 31/389$ (2019.01)   $H01M\ 10/42$ (2006.01)
$H01M\ 10/48$ (2006.01)   $H02J\ 7/00$ (2006.01)

(52) Cooperative Patent Classification (CPC):
G01R 31/367; G01R 31/389; G01R 31/392;
H01M 10/42; H01M 10/48; H02J 7/00; Y02E 60/10

(86) International application number:
PCT/JP2022/035710

(87) International publication number:
WO 2023/149011 (10.08.2023 Gazette 2023/32)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 07.02.2022 JP 2022016957

(71) Applicant: DENSO CORPORATION
Kariya-city, Aichi 448-8661 (JP)

(72) Inventors:
• YOSHIDA, Shuhei
  Kariya-city, Aichi 448-8661 (JP)
• SHIMONISHI, Yuta
  Kariya-city, Aichi 448-8661 (JP)
• TAKIZAWA, Kazuya
  Kariya-city, Aichi 448-8661 (JP)

(74) Representative: TBK
Bavariaring 4-6
80336 München (DE)

(54) **SECONDARY BATTERY STATE DETECTING DEVICE, TRAINING UNIT, AND SECONDARY BATTERY STATE DETECTING METHOD**

(57) A secondary battery state detection device estimates an SOH indicating a degree of deterioration of a secondary battery (10). The secondary battery state detection device includes: a detection unit (20, 30, 60, 70) that detects information indicating a battery state of the secondary battery; a learning unit (75) that learns an SOH estimation model for estimating the SOH; a storage unit (50) that stores the SOH estimation model; a calculation unit (80) that performs to calculate the SOH using the information indicating the battery state of the secondary battery detected by the detection unit and the SOH estimation model stored in the storage unit; and an output unit (85) that outputs an estimation result of the SOH acquired the calculation unit. SOH information and information indicating the battery state having a correlation with the SOH higher than a predetermined correlation among the information indicating the battery state of the secondary battery are defined as learning data. SOH information is defined as output. The information indicating the battery state having the correlation with the SOH higher than the predetermined correlation is defined as input. The SOH estimation model learned by the learning unit is built by synthesizing a regression model using a variance-covariance matrix.

FIG. 1

## Description

### CROSS REFERENCE TO RELATED APPLICATION

This application is based on Japanese Patent Application No. 2022-016957 filed on February 7, 2022, the disclosure of which is incorporated herein by reference.

### TECHNICAL FIELD

The present disclosure relates to a secondary battery state detection device, a learning unit, and a detection method for a secondary battery state.

### BACKGROUND ART

Conventionally, a method for evaluating the deterioration state of a secondary battery has been proposed, for example, in Patent Literature 1. The deterioration state is defined as SOH (i.e., State of Health).

In Patent Literature 1, first, an impedance spectrum of a secondary battery is measured using alternating current in a predetermined frequency range. Next, when the impedance spectrum is represented by a diagram including the arc shape portion on a complex plane defined by the real axis and the imaginary axis, the coordinates of the apex of the arc shape portion are determined. That is, the coordinates are expressed by the real part and the imaginary part of the impedance.

Then, the ratio between the real part and the imaginary part of the impedance, i.e., "tan θ", is calculated. There is a correlation between the deterioration state of the secondary battery and the value of "tan θ" that can be approximated by a simple approximation expression. Therefore, the deterioration state of the secondary battery is evaluated based on the calculated angle θ and the approximation expression.

### PRIOR ART LITERATURES

### PATENT LITERATURE

Patent Literature 1: WO 2012/095913 A

### SUMMARY OF INVENTION

However, in the conventional technique described above, all the impedances in a predetermined frequency range are acquired, so it takes a long time to acquire all the data. Therefore, it takes a long time to diagnose the deterioration state.

Furthermore, the real part of the impedance is necessary for evaluating the deterioration state of a secondary battery. The real part of the impedance is easily affected by a wiring. For example, various influences such as the wiring of an assembled battery configured by secondary batteries, the environment in which the impedance is measured, the metal resistance of the wiring, and the direct current resistance of the wiring are included in the real part of the impedance as measurement errors. For this reason, the accuracy of estimating the deterioration state of the secondary battery decreases when the evaluation uses the real part of the impedance.

Furthermore, although the deterioration state of the secondary battery and the value of "tan θ" are approximated by a simple approximation expression, the secondary battery does not actually deteriorate monotonically. For this reason, the estimation accuracy of the deterioration state of the secondary battery decreases in evaluation using a simple approximation expression.

In view of the above-mentioned points, a first object of the present embodiments is to provide a secondary battery state detection device and a learning unit that can shorten SOH diagnosis time and estimate SOH with high accuracy. A second object of the present embodiments is to provide a detection method for a secondary battery state.

According to a first aspect of the present embodiments, a secondary battery state detection device estimates SOH indicating the degree of deterioration of a secondary battery, and includes a detection unit, a learning unit, a storage unit, a calculation unit, and an output unit.

The detection unit detects information indicating the battery state of the secondary battery. The learning unit learns an SOH estimation model for estimating the SOH. The storage unit stores the SOH estimation model. The calculation unit performs to calculate the SOH using the information indicating the battery state of the secondary battery detected by the detection unit and the SOH estimation model stored in the storage unit. The output unit outputs the SOH estimation result acquired by the calculation unit.

Then, the SOH estimation model learned by the learning unit is built by synthesizing a regression model using a variance-covariance matrix, in which the SOH information and information indicating the battery state that has a correlation with the SOH higher than a predetermined correlation among the information indicating the battery state of the secondary battery are used as learning data, the SOH information is the output data, and the information indicating the battery state that has the correlation with the SOH higher than the predetermined correlation is the input data.

According to a second aspect of the present embodiments, the learning unit is applied to a secondary battery state detection device that estimates SOH indicating the degree of deterioration of the secondary battery, and builds an SOH estimation model for estimating the SOH. The learning unit builds the SOH estimation model by synthesizing a regression model using a variance-covariance matrix, in which the SOH information and information indicating the battery state that has a correlation with the SOH higher than a predetermined correlation among the information indicating the battery state of the secondary battery are used as learning data, the SOH information is the output data, and the information indicating the battery state that has the correlation with the SOH higher than the predetermined correlation is the input data.

According to a third aspect of the present embodiments, a detection method for a secondary battery state is for estimating SOH indicating the degree of deterioration of the secondary battery. The detection method for the secondary battery state includes: a first step of acquiring SOH information; a second step of acquiring information indicating the battery state of the secondary battery, and acquiring information indicating the battery state having a correlation with the SOH higher than a predetermined correlation among the information indicating the battery state of the secondary battery; a third step of building the SOH estimation model by synthesizing a regression model using a variance-covariance matrix, in which the SOH information acquired in the first step, and the information indicating the battery state that has the correlation with the SOH higher than the predetermined correlation acquired in the second step; and a fourth step of inputting the information indicating the present battery state of the secondary battery into the SOH estimation model built in the third step to estimate the SOH of the secondary battery.

According to the above features, the SOH is calculated by inputting the information indicating the battery state of the secondary battery into the SOH estimation model. Therefore, the time required for diagnosing the SOH of the secondary battery can be shortened. Furthermore, since the regression model using the variance-covariance matrix is a nonlinear model, it has higher accuracy in estimating the deterioration state of the secondary battery than a monotonous linear model. Therefore, the SOH of the secondary battery can be estimated with high accuracy.

BRIEF DESCRIPTION OF DRAWINGS

The above and other objects, features and advantages of the present disclosure will be more clearly understood from the following detailed description with reference to the accompanying drawings. In the accompanying drawings:

FIG. 1 is a diagram showing the configuration of a secondary battery state detection device according to an embodiment;
FIG. 2 is a diagram for explaining the contents of model building and SOH estimation;
FIG. 3 is a diagram for explaining complex impedance Z;
FIG. 4 is a diagram showing a Nyquist plot of complex impedance Z of a secondary battery in a laboratory environment and an in-vehicle environment;
FIG. 5 is a diagram showing the real component Zreal of the Nyquist plot shown in FIG. 4;
FIG. 6 is a diagram showing the reactance component Zimag of the Nyquist plot shown in FIG. 4;
FIG. 7 is a diagram showing a method for estimating the SOH of a secondary battery;
FIG. 8 is a diagram showing the results of measuring the relationship between each frequency and the reactance component Zimag at each temperature;
FIG. 9 is a diagram showing a Nyquist plot before interpolating the data of the reactance component ZimagB;
FIG. 10 is a diagram showing a Nyquist plot after interpolating the data of the reactance component ZimagB;
FIG. 11 is a diagram showing an example in which each function of the secondary battery state detection device is arranged inside the mobility device;
FIG. 12 is a diagram showing an example in which each function of the secondary battery state detection device is arranged inside and outside the mobility device;
FIG. 13 is a diagram showing an example in which each function of the secondary battery state detection device is arranged inside and outside the mobility device;
FIG. 14 is a diagram showing an example in which each function of the secondary battery state detection device is arranged outside the mobility device;
FIG. 15 is a diagram showing an example in which each function of the secondary battery state detection device is arranged outside the mobility device;
FIG. 16 is a diagram for explaining updating of the SOH estimation model in the second embodiment;

FIG. 17 is a diagram showing the input data of learning data and the estimation accuracy of the SOH in the third embodiment;

FIG. 18 is a diagram showing contents of updating input/output restriction parameters in the fourth embodiment;

FIG. 19 is a diagram showing an example of charge/discharge control in the fourth embodiment;

FIG. 20 is a diagram showing an example of charge/discharge control in the fourth embodiment;

FIG. 21 is a diagram showing the variation of the available capacity of the secondary battery in FIG. 20; and

FIG. 22 is a diagram for explaining the details of authentication in the fourth embodiment.

EMBODIMENTS FOR CARRYING OUT INVENTION

The following describes embodiments for carrying out the present disclosure with reference to the drawings. In the respective embodiments, parts corresponding to matters already described in the preceding embodiments are given reference numbers identical to reference numbers of the matters already described. The same description is therefore omitted depending on circumstances. In a case where only a part of the configuration is described in each embodiment, the other embodiments described above can be applied to the other part of the configuration. The parts may be combined even if it is not explicitly described that the parts can be combined. The embodiments may be partially combined even if it is not explicitly described that the embodiments can be combined, provided there is no harm in the combination.

(First Embodiment)

Hereinafter, a first embodiment will be described with reference to the drawings. A secondary battery state detection device according to the present embodiment is a device that estimates SOH indicating the degree of deterioration of the secondary battery. Further, the detection method for the secondary battery state is a method of estimating SOH, which indicates the degree of deterioration of the secondary battery.

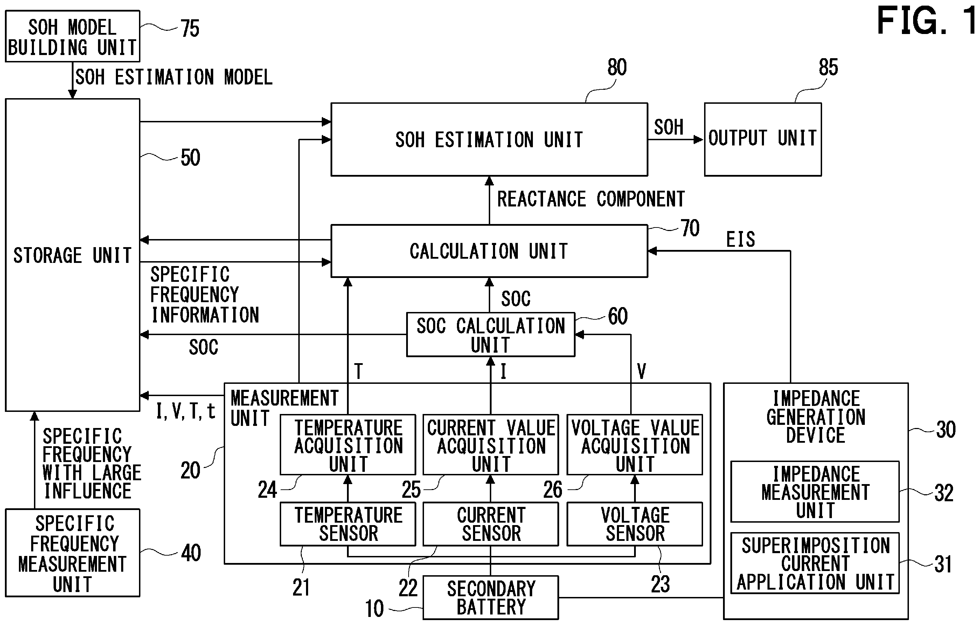

As shown in FIG. 1, a secondary battery state detection device is provided for a secondary battery 10. The secondary battery 10 constitutes a battery module in which a plurality of battery cells are connected in series. Each battery cell is, for example, a lithium ion secondary battery. The secondary battery 10 constitutes a power supply unit of an electric vehicle such as an electric car or a hybrid car. The battery module may include a configuration in which each battery cell is connected in parallel.

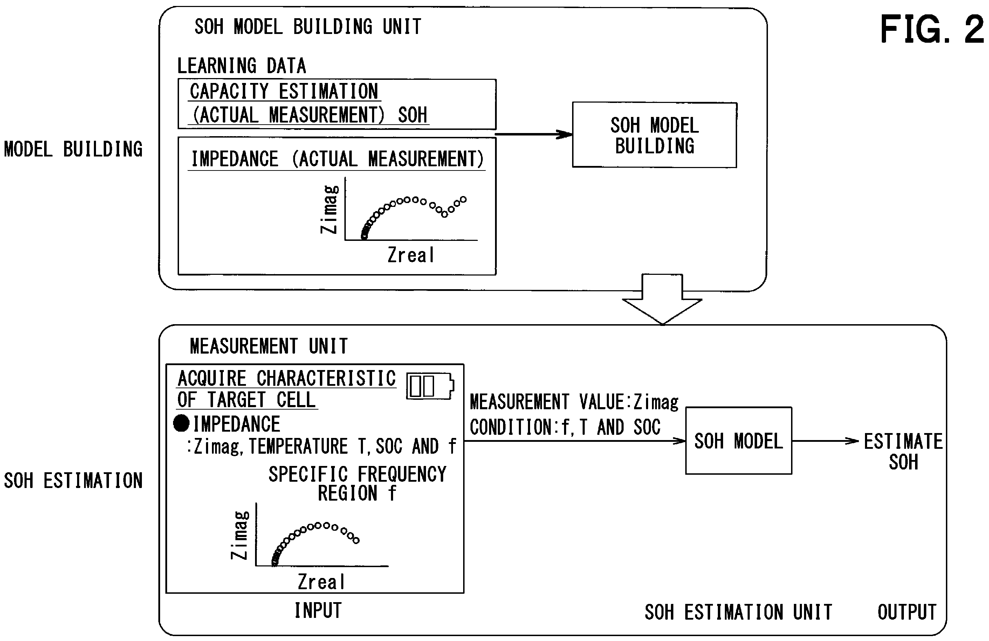

As shown in FIG. 2, the secondary battery state detection device has a function of building an SOH estimation model for estimating the SOH of the secondary battery 10, and a function of calculating the SOH using the SOH estimation model. In the model building, the actual measurement value of the battery capacity of the secondary battery 10 and the actual measurement value of the impedance of the secondary battery 10 are used as learning data. In the SOH estimation, the SOH is calculated by performing calculations based on measurement values and conditions according to the SOH estimation model built by the model building. The measurement value is the imaginary part Zimag of the impedance of the secondary battery 10. The conditions are the temperature T of the secondary battery 10, the SOC, and the specific frequency f.

As shown in FIG. 1, the secondary battery state detection device includes a measurement unit 20, an impedance generation device 30, a specific frequency calculation unit 40, a storage unit 50, an SOC calculation unit 60, a calculation unit 70, an SOH model building unit 75, an SOH estimation unit 80 and an output unit 85.

The measurement unit 20 acquires the temperature, current, and voltage of the secondary battery 10 as information indicating the battery state of the secondary battery 10. The measurement unit 20 includes a temperature sensor 21, a current sensor 22, a voltage sensor 23, a temperature acquisition unit 24, a current value acquisition unit 25, and a voltage value acquisition unit 26.

The temperature sensor 21 measures the temperature of secondary battery 10. The temperature sensor 21 is disposed in the secondary battery 10. The current sensor 22 measures a current value of the secondary battery 10. The current sensor 22 is connected to the secondary battery 10. The voltage sensor 23 measures a voltage value of the secondary battery 10. The voltage sensor 23 is connected to the secondary battery 10. Each sensor 21 to 23 outputs a detection signal to each acquisition unit 24 to 26 at any time.

The temperature acquisition unit 24, the current value acquisition unit 25, and the voltage value acquisition unit 26 are data acquisition units for periodically acquiring each data of the temperature, the current value, and the voltage value of the secondary battery 10.

The temperature acquisition unit 24 periodically acquires information on the temperature T of the secondary battery 10 measured by the temperature sensor 21. The temperature of the secondary battery 10 is information indicating the battery state that has a correlation with the SOH higher than a predetermined correlation. For example, the temperature acquisition unit 131 calculates the temperature T from the temperature distribution of the secondary battery 10 acquired over a certain period of time. For example, the temperature T can be an average value calculated from a frequency distribution of the temperature of the secondary battery 10 acquired over a certain period of time. The temperature acquisition unit 131 outputs information on the temperature T of the secondary battery 10 to the calculation unit 70.

As the temperature T, in order to reduce the calculation load, it is also possible to use, for example, an average value of the temperature of the secondary battery 10 acquired over a certain period of time.

The current value acquisition unit 25 periodically acquires information on the current I of the secondary battery 10 measured by the current sensor 22. For example, the current value acquisition unit 25 calculates the current I from the distribution of the current of the secondary battery 10 acquired over a certain period of time. For example, the current I can be an average value calculated from the frequency distribution of the current of the secondary battery 10 acquired over a certain period of time. The current value acquisition unit 25 outputs information about the current I of the secondary battery 10 to the calculation unit 70.

As the current I, in order to reduce the calculation load, it is also possible to use, for example, an average value of the current of the secondary battery 10 acquired over a certain period of time.

The voltage value acquisition unit 26 periodically acquires information on the voltage V of the secondary battery 10 measured by the voltage sensor 23. For example, the voltage V can be an average value calculated from a frequency distribution of voltage values of the secondary battery 10 acquired over a certain period of time. The voltage value acquisition unit 26 outputs information on the voltage V of the secondary battery 10 to the calculation unit 70.

As the voltage V, in order to reduce the calculation load, it is also possible to use, for example, an average value of the voltage of the secondary battery 10 acquired over a certain period of time.

The measurement unit 20 also stores information on the temperature T acquired by the temperature acquisition unit 24, information on the current I acquired by the current value acquisition unit 25, information on the voltage V acquired by the voltage value acquisition unit 26, and the measurement time t of each value in the storage unit 50 as time series data.

Furthermore, the measurement unit 20 measures the battery capacity of the secondary battery 10 based on the DC current. For example, the measurement unit 20 measures the battery capacity of the secondary battery 10 by integrating the DC current charged during the period from the time when measurement is started until the time when the secondary battery 10 reaches a full charge state. Here, it is also possible to use other measurement methods to measure the battery capacity.

The measurement unit 20 is used to acquire information indicating the battery state of the secondary battery 10 during the SOH estimation. The measurement unit 20 may be used to acquire information indicating the battery state of the secondary battery 10 during the model building.

The impedance generation device 30 is a device that acquires the impedance of the secondary battery 10 by an electrochemical impedance spectroscopy (i.e., EIS). The impedance is a physical quantity that changes depending on the degree of deterioration of the secondary battery 10. The impedance data EIS is a sensing data measured by the impedance generation device 30. The impedance generation device 30 includes a superimposition current application unit 31 and an impedance measurement unit 32.

The superimposition current application unit 31 applies a superimposition current in which a plurality of frequency components are superimposed to the secondary battery 10. By using the superimposition current, it is possible to collectively acquire the battery voltage when the current with a plurality of frequencies is applied to the secondary battery 10.

For example, a multiple sine wave can be employed as the superimposition current. As the superimposition current, a rectangular wave, a sawtooth wave, or a triangular wave can also be used. Here, with a harmonic wave for a fundamental frequency as the superposition frequency, the current value greatly decreases every time the order increases, but the current value does not decrease with the multiple sine wave. Thus, by employing the multiple sine wave as the superimposition current, high measurement accuracy can be maintained. In the multiple sine wave, the frequency to be superimposed is not particularly limited and can be set as appropriate.

The impedance measurement unit 32 acquires the current value of the superimposition current applied to the secondary battery 10 by the superimposition current application unit 31. Furthermore, the impedance measuring unit 32 acquires a response voltage when the superimposition current is applied to the secondary battery 10. Therefore, the impedance is a complex impedance calculated by dividing the response voltage by an alternating current as a complex number having information of an absolute value and a phase after the response voltage corresponding to the alternating current applied to the secondary battery 10 is measured.

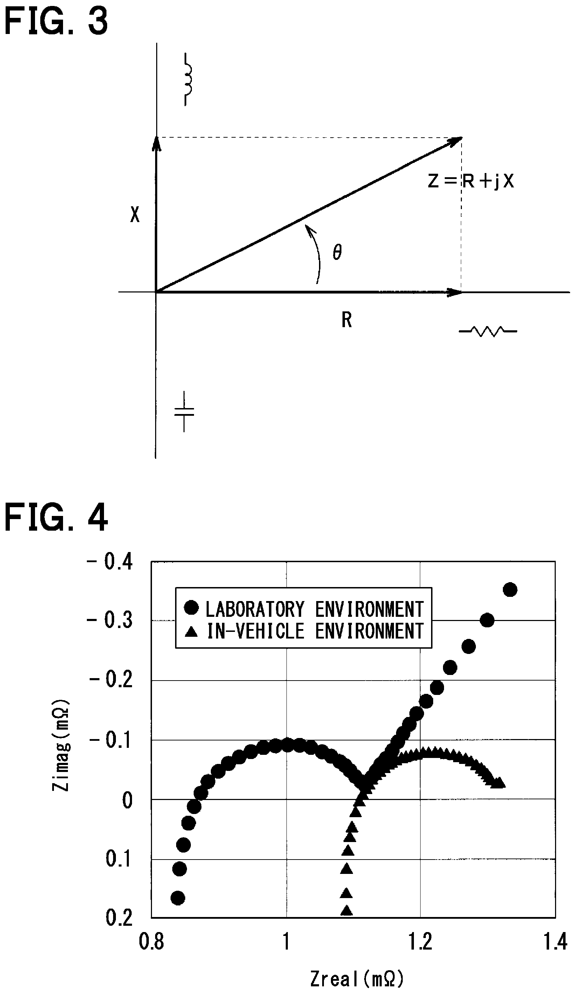

That is, as shown in FIG. 3, the complex impedance Z is expressed as an expression of $"Z = R + jX"$. Here, R is the real part of the complex impedance Z and is a resistance component. X is the imaginary part of the complex impedance Z, and is the reactance component Zimag. θ is the phase between the real part and the imaginary part.

For example, the impedance measurement unit 32 calculates the complex impedance of the secondary battery 10 for each of the plurality of frequency components using a discrete Fourier transform. As the current value and the voltage value at the time of applying the superimposition current, detection values of the current sensor 22 and the voltage sensor 23 can be used. A fast discrete Fourier transform (i.e., FFT) can be employed as the discrete Fourier transform.

The impedance generation device 30 outputs impedance data EIS of the calculated complex impedance Z for each of the plurality of frequency components to the calculation unit 70. The impedance generation device 30 may store the impedance data EIS in the storage unit 50.

The impedance generation device 30 can be configured using, for example, a power conversion device that constitutes an in-vehicle power control unit. Thereby, there is no need to separately provide the impedance generation device 30 including the superimposition current generation unit. A superimposition current of a large current can be generated. Therefore, a device configuration suitable for on-board diagnosis of the secondary battery 10 for a vehicle mounted therein can be provided. Alternatively, the superimposition current generation unit can be disposed in an in-vehicle charge device which is not illustrated or a charge device provided outside.

The specific frequency calculation unit 40 is a device that acquires information on a specific frequency necessary for estimating the SOH of the secondary battery 10 in advance by the electrochemical impedance spectroscopy. The specific frequency calculation unit 40 may or may not be mounted in the vehicle.

That is, the specific frequency is a frequency determined by machine learning using the impedance data EIS of the secondary battery 10 acquired in advance. Further, the specific frequency is a frequency that has a large influence on the SOH of the secondary battery 10.

A degree of influence on the SOH of the secondary battery 10 corresponds to a strength of a correlation between the imaginary component Zimage of the complex impedance and the SOH. That is, the reactance component Zimag of the complex impedance calculated based on the alternating current of a specific frequency that has a high correlation with the SOH of the secondary battery 10 and the specific frequency indicate information about a battery state that has a correlation with the SOH of the secondary battery 10 higher than a predetermined correlation. The specific frequency is, for example, a specific frequency in a frequency range greater than 1 Hz, preferably greater than 10 Hz.

The structure of the secondary battery 10 differs depending on the electric vehicle in which the secondary battery 10 is mounted. Therefore, the characteristics of the secondary battery 10 differ depending on the vehicle type, for example. Therefore, the specific frequency differs depending on the configuration of the secondary battery 10. The specific frequency calculation unit 40 is used to acquire a specific frequency corresponding to the secondary battery 10 mounted in the electric vehicle. The method for acquiring the specific frequency will be explained later.

The specific frequency is limited in advance by a dimension reduction method. Specifically, a secondary battery having the same configuration as the secondary battery 10 shown in FIG. 1 is prepared and a specific frequency is determined.

In the first process, the correlation between the SOH of each specific frequency in N dimensions and the reactance component Zimag of the complex impedance Z is calculated. For this reason, the secondary battery 10 is deteriorated in advance under various conditions. The deterioration conditions include, for example, a case where the secondary battery 10 is left unattended at different temperatures and different SOCs, and a case where the secondary battery 10 is repeated charging and discharging at different temperatures and different SOCs. Further, the transition of the SOH and the reactance component Zimag of the complex impedance Z until the end of the life of the secondary battery 10 are acquired as data.

Thereby, a correlation between the relationship between the reactance component Zimag of the complex impedance Z and the SOH and a certain range of frequencies can be obtained. The larger the value indicating the relationship between the reactance component Zimag of the complex impedance Z and the SOH, the higher the importance.

Here, if all frequencies within a certain range are used to estimate the SOH, an overfitting may occur. Therefore, the error in the extrapolation area increases. Therefore, the larger the number of frequencies, that is, the larger the number of dimensions, is not necessarily better. Therefore, SISSO, which is a type of machine learning, is used to calculate combinations of specific frequencies up to N dimensions. In other words, it is determined which frequency within a certain range of frequencies is to be used for SOH estimation. The frequency determined thereby becomes the specific frequency. By specifying several frequencies to be used for SOH estimation, the versatility of the specific frequencies can be increased.

The above machine learning leads to a combination of the number of dimensions and a specific frequency. In the case of two dimensions, the specific frequency is determined to be two frequencies. Similarly, in the case of three dimensions, three frequencies are determined. In the case of four dimensions, five dimensions, and the like, a plurality of frequencies are similarly determined.

The storage unit 50 is, for example, a rewritable nonvolatile memory. The storage unit 50 stores a program for controlling the measurement unit 20, the impedance generation device 30, the SOC calculation unit 60, the calculation unit 70, and the SOH estimation unit 80. The storage unit 50 stores the measurement results of the measurement unit 20, the calculation results of the SOC calculation unit 60, and the calculation results of the calculation unit 70. This information is used as learning data for the SOH estimation unit 80.

Furthermore, the storage unit 50 stores the SOH estimation model acquired by the SOH model building unit 75. The SOH estimation model is used when calculating the SOH at the time of SOH estimation in the SOH estimation unit 80.

Furthermore, the storage unit 50 stores information on a plurality of specific frequencies within the frequency range used in the electrochemical impedance spectroscopy measurements in the impedance generation device 30. The information on a plurality of specific frequencies is input in advance from the specific frequency calculation unit 40.

The SOC calculation unit 60 calculates a charge rate indicating the remaining battery level of the secondary battery 10 as information indicating the battery state of the secondary battery 10. The charge rate of the secondary battery 10 is expressed as a percentage of the remaining level to the fully charged capacity of the secondary battery 10. The charge rate of the secondary battery 10 is defined as SOC (i.e., State Of Charge). The SOC of the secondary battery 10 is information indicating the battery state that has a correlation with the SOH higher than a predetermined correlation.

For example, the SOC calculation unit 60 calculates the integrated value of the current value of the secondary battery 10 acquired by the current value acquisition unit 25, and calculates the charge rate of the secondary battery 10 based on the integrated value. The SOC information calculated by the SOC calculation unit 60 is stored in the storage unit 50 and is output to the calculation unit 70. Here, the SOC calculation unit 60 may be configured as a part of the measurement unit 20 and/or the calculation unit 70. The SOC calculation unit 60 may be used to acquire the SOC during the model building.

The calculation unit 70 calculates a reactance component Zimag of the complex impedance Z as information indicating the battery state of the secondary battery 10 based on the alternating current of a specific frequency applied to the secondary battery 10. That is, the calculation unit 70 acquires the reactance component Zimag of the complex impedance Z when an alternating current corresponding to a specific frequency flows through the secondary battery 10. When there are four specific frequencies, the calculation unit 70 acquires four reactance components Zimag (x1, x2, x3, x4).

Further, the calculation unit 70 converts the reactance component Zimag to a calculation value corresponding to a predetermined temperature and a predetermined SOC based on the temperature and the SOC of the secondary battery 10 when the reactance component Zimag of the complex impedance Z is acquired according to the temperature conversion model and the SOC conversion model. When there are four specific frequencies, the calculation value Zimag (x1, x2, x3, x4) is converted to predetermined SOC based on the temperature and the SOC based on the temperature and the SOC of the secondary battery 10 at the time of observation and the reactance component Zimag (x01, x02, x03, x04) as the observation value.

The predetermined temperature is, for example, 25°C. The predetermined SOC is, for example, 50%. Thereby, it is possible to estimate the SOH that does not depend on the environment in which the secondary battery 10 is placed or the state of the secondary battery 10. Furthermore, model errors due to the temperature correction and the SOC correction can be reduced.

Here, the relationship between the reactance component Zimag at each frequency of the secondary battery 10 acquired in advance and the temperature of the secondary battery 10 is represented by a linear model. Further, the relationship between the reactance component Zimag at each frequency of the secondary battery 10 acquired in advance and the SOC of the secondary battery 10 is represented by a linear model. Therefore, the calculation unit 70 calculates the reactance component Zimag, which is a calculated value, based on a linear model of the reactance component Zimag at each frequency of the secondary battery 10 acquired in advance, and the temperature and the SOC of the secondary battery 10.

The calculation unit 70 may be used to acquire the reactance component Zimag during the model building.

The SOH model building unit 75 learns an SOH estimation model for estimating the SOH. The SOH model building unit 75 uses the SOH information of the secondary battery 10 and information indicating a battery state having a correlation with the SOH higher than a predetermined correlation as learning data. In addition, the SOH model building unit 75 synthesizes a regression model using a variance-covariance matrix, with the SOH information of the secondary battery 10 as an output and information indicating a battery state that has a correlation with the SOH higher than a predetermined correlation as an input, so as to build the SOH estimation model. The SOH model building unit 75 outputs the learned SOH estimation model to the storage unit 50.

In this embodiment, the SOH information is the battery capacity of the secondary battery 10 measured based on current. The battery capacity is measured by the measurement unit 20 or another measurement device. Further, the information indicating the battery state having the correlation with the SOH higher than a predetermined correlation is a reactance component Zimag of the complex impedance calculated based on an alternating current of a specific frequency. The reactance component Zimag is measured by the measurement unit 20, the calculation unit 70, and other measurement devices.

Here, the use of the reactance component Zimag of the complex impedance Z as a feature value will be explained. As shown in FIG. 4, the complex impedance Z of the secondary battery 10 is expressed as a Nyquist plot with the real component Zreal as the horizontal axis and the reactance component Zimag as the vertical axis. The complex impedance plots are different between a laboratory environment in which the secondary battery 10 is placed in a laboratory and an in-vehicle environment in which the secondary battery 10 is mounted in a vehicle.

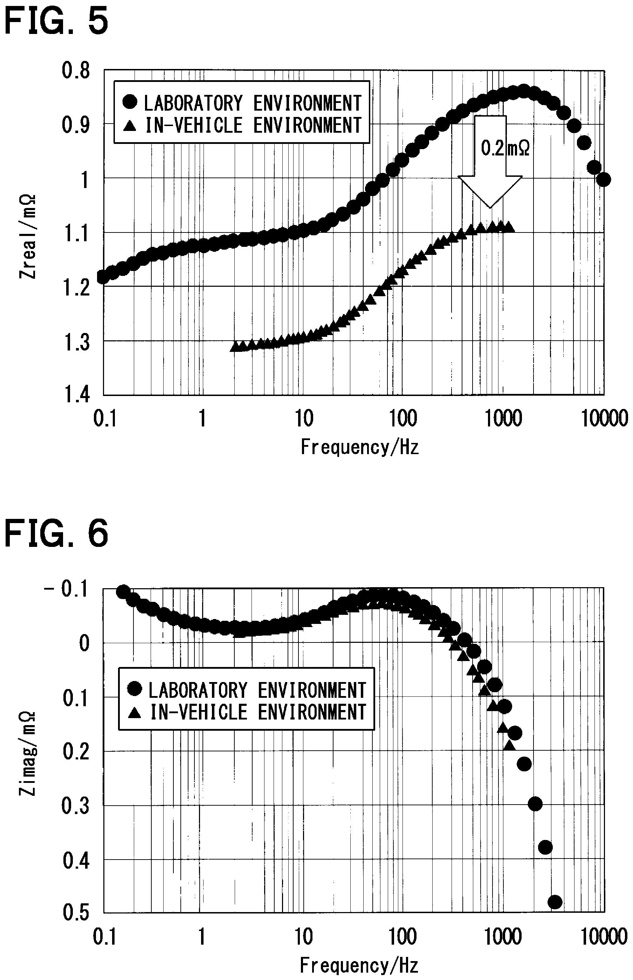

Specifically, regarding the real component Zreal of the complex impedance Z, as shown in FIG. 5, the real component Zreal in the in-vehicle environment is smaller by 0.2 mΩ than the real component Zreal in the laboratory environment This is because the contact resistance between the cells of the secondary battery 10, the current collection resistance inside the cells, and the like are affected.

On the other hand, as for the reactance component Zimag of the complex impedance Z, as shown in FIG. 6, the difference between the reactance component Zimag in the in-vehicle environment and the reactance component Zimag in the laboratory environment is small. This means that the reactance component Zimag is not affected by the measurement environment of the secondary battery 10. Therefore, in order to estimate the SOH of the secondary battery 10, the reactance component Zimag of the complex impedance Z is used as a feature value.

A regression model using a variance-covariance matrix will be explained. As a precondition, the number of samples for the model building is defined as n, and the value of the target variable y for the (n+1)-th sample. For n samples, there is a value of y and a value for explanation variable X, and for (n+1)-th sample, there is only a value for X. Here, "X" is unrelated to the imaginary part X of the complex impedance Z shown in FIG. 3.

In the first step, a linear model of "y = Xb" is assumed, where b is the regression coefficient. The linear model is expressed as shown in expression (1) below.

(Expression 1)

$$
\begin{matrix} y & X & b \end{matrix}
$$

$$
\begin{bmatrix} y^{(1)} \\ M \\ y^{(i)} \\ M \\ M \\ y^{(n)} \end{bmatrix} = \begin{bmatrix} x_1^{(1)} & L & x_j^{(1)} & L & x_m^{(1)} \\ M & & M & & M \\ x_1^{(i)} & L & x_j^{(i)} & L & x_m^{(i)} \\ M & & M & & M \\ M & & M & & M \\ x_1^{(n)} & L & x_j^{(n)} & L & x_m^{(n)} \end{bmatrix} \begin{bmatrix} b_1 \\ M \\ b_j \\ M \\ b_m \end{bmatrix} \quad \cdots \ (1)
$$

In expression (1), n is the number of samples, and m is the number of explanation variables. Further, $y^{(n)}$ corresponds to the SOH which is to be estimated. And, $x_n^{(n)}$ corresponds to the reactance component Zimag at any specific frequency. Here, no values are entered in L or M.

In the second step, the y relationship between samples is determined by the X relationship between samples.

Also, regarding the normal distribution in y of n samples, the average of the normal distribution of $y^{(i)}$ is defined by mi, the variance of the normal distribution of $y^{(i)}$ is defined by $\sigma_{yi}^2$, and the covariance of the normal distribution of $y^{(i)}$ and the normal distribution of $y^{(j)}$ is defined by $\sigma_{yi,j}^2$. Here, $\sigma_{yi}$ is the same as $\sigma_{yi,i}$. Thereby, the average vector m is expressed by the following expression (2).

(Expression 2)

$$
m = \begin{bmatrix} m_1 \\ M \\ m_i \\ M \\ m_n \end{bmatrix} \quad \cdots \ (2)
$$

The variance-covariance matrix Σ is expressed by the following expression (3).

(Expression 3)

$$\Sigma = \begin{bmatrix} \sigma_{y1,1}^{2} & L & \sigma_{y1,j}^{2} & L & \sigma_{y1,n}^{2} \\ M & & M & & M \\ \sigma_{yi,1}^{2} & L & \sigma_{yi,j}^{2} & L & \sigma_{yi,n}^{2} \\ M & & M & & M \\ \sigma_{yn,1}^{2} & L & \sigma_{yn,j}^{2} & L & \sigma_{yn,n}^{2} \end{bmatrix} \quad \cdots (3)$$

In this way, the variance-covariance matrix $\Sigma$ is expressed using the reactance component Zimag.

In the third stage, it is expanded to a nonlinear model using kernel tricks. Since the linear model, that is, the original space is expressed as an expression of "$y^{(i)} = x^{(i)}b$"; it is mapped to a high-dimensional space by setting "$x \rightarrow \phi(x)$". Therefore, the nonlinear model function, that is, the high-dimensional space is expressed by the following expression (4). (Expression 4)

$$y^{(i)} = \phi\left(x^{(j)}\right) b \qquad \ldots (4)$$

Further, the covariance $\sigma_{yi,j}^{2}$ is expressed by the following expression (5). (Expression 5)

$$\sigma_{yi,j}^{2} = \sigma_b^2 \, x^{(i)} x^{(j)\,T} \qquad \ldots (5)$$

Therefore, the covariance $\sigma_{yi,j}^{2}$ is expressed by the following expression (6) using the kernel function K. (Expression 6)

$$\sigma_{yi,j}^{2} = \sigma_b^2 \, \phi\left(x^{(i)}\right) \phi\left(x^{(j)}\right)^{T}$$

$$= K\left(x^{(i)}, x^{(j)}\right) \qquad \cdots (6)$$

Here, the kernel function K is expressed by the following expression (7). (Expression 7)

$$K\left(x^{(i)}, x^{(j)}\right) = \theta_0 \, exp\left\{-\frac{\theta_1}{2}\left\| x^{(i)} - x^{(j)}\right\|^2\right\} + \theta_2 \qquad \ldots (7)$$

As another kernel function K, the following (8) may be used. (Expression 8)

$$K\left(x^{(i)}, x^{(j)}\right) = \theta_0 \, exp\left\{-\frac{\theta_1}{2}\left\| x^{(i)}\right.\right.$$

$$\left.\left. - x^{(j)}\right\|^2\right\} + \theta_2 + \theta_3 \sum_{k=1}^{m} x_k^{(i)} x_k^{(j)} \qquad \ldots (8)$$

Alternatively, the following expression (9) may be used as another kernel function K. (Expression 9)

$$K\left(x^{(i)}, x^{(j)}\right) = \theta_0 \, exp\left\{-\frac{1}{2}\sum_{k=1}^{m}\theta_{1,k}\left(x_k^{(i)} - x_k^{(j)}\right)^2\right\} + \theta_2 \qquad \dots (9)$$

Each kernel function K shown in expressions (7) to (9) is an example, and other expressions may be used. It may be preferable to employ the kernel function K that provides the highest SOH estimation accuracy.

The average vector m in the nonlinear model is expressed by the following expression (10).

(Expression 10)

$$m = \begin{bmatrix} m_1 \\ M \\ m_i \\ M \\ m_n \end{bmatrix} = \begin{bmatrix} 0 \\ M \\ 0 \\ M \\ 0 \end{bmatrix} \qquad \cdots (10)$$

Further, the variance-covariance matrix $\Sigma$ in the nonlinear model is expressed by the following expression (11).

(Expression 11)

$$\Sigma = \begin{bmatrix} \sigma_{y1,1}^2 & L & \sigma_{y1,j}^2 & L & \sigma_{y1,n}^2 \\ M & & M & & M \\ \sigma_{yi,1}^2 & L & \sigma_{yi,j}^2 & L & \sigma_{yi,n}^2 \\ M & & M & & M \\ \sigma_{yn,1}^2 & L & \sigma_{yn,j}^2 & L & \sigma_{yn,n}^2 \end{bmatrix}$$

$$= \sigma_b^2 \begin{bmatrix} x^{(1)}x^{(1)T} & L & x^{(1)}x^{(j)T} & L & x^{(1)}x^{(n)T} \\ M & & M & & M \\ x^{(i)}x^{(1)T} & L & x^{(i)}x^{(j)T} & L & x^{(i)}x^{(n)T} \\ M & & M & & M \\ x^{(n)}x^{(1)T} & L & x^{(n)}x^{(j)T} & L & x^{(n)}x^{(n)T} \end{bmatrix} \qquad \cdots (11)$$

In this way, in the variance-covariance matrix $\Sigma$, the reactance component Zimag is expressed using the kernel function K.

In the fourth step, since y includes noise, which is a measurement error, the magnitude of the noise is estimated and the relationship in the above-mentioned second step is determined again.

In the fifth step, the relationship between the X of the n samples and the X of the (n+1)-th sample is acquired from the fourth step and the estimation value of the SOH, that is, the value of the (n+1)-th y is estimated based on the n values of y.

In addition, when synthesizing a regression model using a variance-covariance matrix, the SOH estimation unit 80 interpolate the data when a predetermined time interval exists between from when the reactance component Zimag was acquired last time until when the reactance component Zimag is acquired the present time. This interpolation increases the number of pieces of data for the reactance component Zimag, so that the accuracy of estimation of the SOH of the secondary battery 10 is improved.

The SOH estimation unit 80 calculates the SOH using information indicating the battery state of the secondary battery 10 and the SOH estimation model stored in the storage unit 50. Specifically, the SOH estimation unit 80 uses the SOH estimation model stored in the storage unit 50, the reactance component Zimag, the specific frequency, the SOC, and the temperature acquired by the measurement unit 20, the SOC calculation unit 60, and the calculation unit 70 so as to estimate the SOH of the secondary battery 10. The SOH estimation unit 80 outputs the SOH calculation result to the output unit 85.

The output unit 85 outputs the SOH estimation result acquired by the SOH estimation unit 80. The output unit 85 is, for example, a screen of a user's mobile information terminal, a navigation panel, a meter panel, and the like of an electric vehicle.

The above is the overall configuration of the secondary battery state detection device. In the secondary battery state detection device, the measurement unit 20, the impedance generation device 30, the SOC calculation unit 60, the calculation unit 70, the SOH model building unit 75, the storage unit 50, the SOH estimation unit 80, and the output unit 85 are each independently configured. That is, the measurement unit 20, the impedance generation device 30, the SOC calculation unit 60, the calculation unit 70, the SOH model building unit 75, the storage unit 50, the SOH estimation unit 80, and the output unit 85 are each configured as a dedicated module.

For example, it may be also possible that the measurement unit 20 and the impedance generation device 30 are mounted on an electric vehicle, and the SOC calculation unit 60, the calculation unit 70, the storage unit 50, and the SOH estimation unit 80 are arranged in the cloud. Here, it is possible to design which modules are placed where. Since each module is independent in this way, the battery diagnosis can be performed without updating the model each time.

The impedance generation device 30 may be included in the measurement unit 20. The SOC calculation unit 60 may be included in the measurement unit 20 or the calculation unit 70. Alternatively, the SOC calculation unit 60 and the calculation unit 70 may be included in the measurement unit 20. Alternatively, the SOC calculation unit 60 and the calculation unit 70 may be included in the SOH estimation unit 80.

Next, a method of learning the SOH estimation model in the SOH model building unit 75 will be explained. The learning of the SOH estimation model is performed by acquiring actual measured values of the secondary battery 10 as learning data, as shown in the upper part of FIG. 2. Generally, the SOH model is built in a laboratory or the like before the secondary battery state detection device is applied to an electric vehicle.

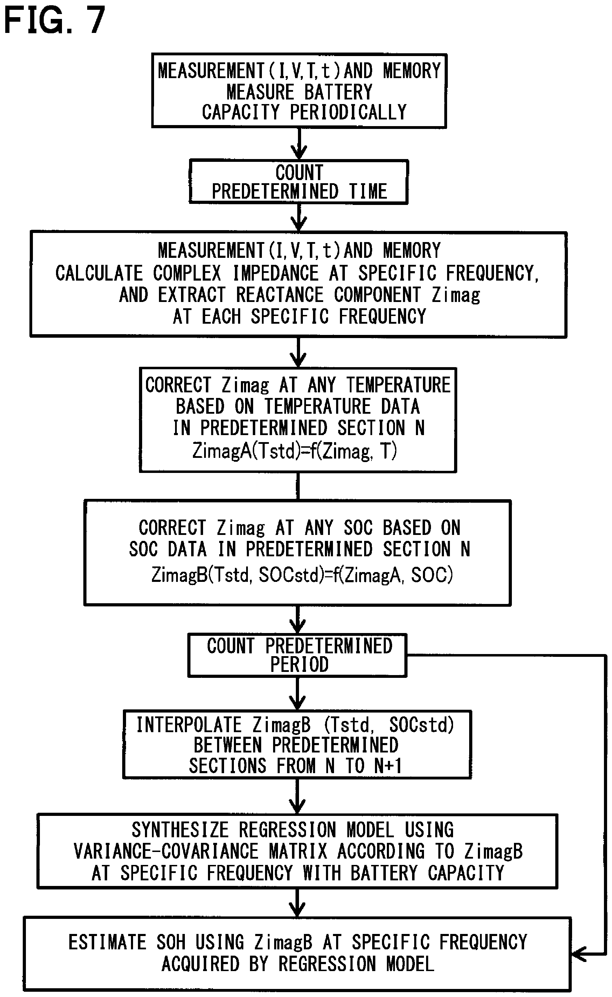

As shown in FIG. 7, in the first step, the measurement unit 20 in the secondary battery state detection device respectively measures current I, voltage V, temperature T, and measurement time t thereof as information indicating the battery state of the secondary battery 10, and then, stores them in the storage unit 50.

Furthermore, the measurement unit 20 periodically measures the battery capacity as SOH information. Here, the secondary battery 10 is deteriorated at various levels of deterioration. Thereby, the battery capacity at each deterioration level can be acquired. The battery capacity measured by the measurement unit 20 is used as the checking result of the estimated SOH, that is, the output of the regression model using the variance-covariance matrix $\Sigma$.

In the second step, a predetermined period of time is counted. The predetermined period is a relatively long period of time, such as half a year or one year.

Subsequently, in the third step, the measurement unit 20 measures the current I, the voltage V, the temperature T, and the measurement time t thereof as information indicating the battery state of the secondary battery 10, and stores them in the storage unit 50. Further, the calculation unit 70 calculates the complex impedance Z at a specific frequency, and extracts a reactance component Zimag for each specific frequency as information indicating the battery state of the secondary battery 10. Thereby, the reactance component Zimag of each condition at each deterioration level can be acquired. The reactance component Zimag is information indicating a battery state that has a correlation with the SOH higher than a predetermined correlation out of the information indicating the battery state of the secondary battery 10.

In the fourth step, the reactance component Zimag in the predetermined unit N is corrected to a reactance component Zimag corresponding to an any temperature using a temperature conversion model. The predetermined period N is, for example, a period of time such as one day or one week.

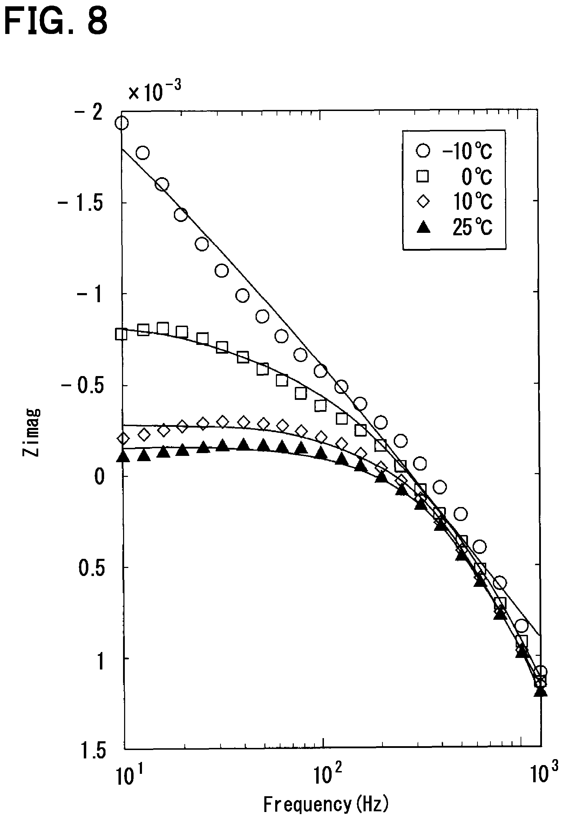

Specifically, based on the temperature of the secondary battery 10 at the time of acquiring the reactance component Zimag, the reactance component Zimag is converted to a calculation value corresponding to a predetermined temperature. Therefore, as shown in FIG. 8, the relationship between the reactance component Zimag at each frequency of the secondary battery 10 and the temperature of the secondary battery 10 is acquired in advance.

Then, a calculation value is calculated based on a linear regression model of the reactance component Zimag at each frequency of the secondary battery 10 acquired in advance and the temperature of the secondary battery 10. That is, based on the linear function relationship between the temperature of the secondary battery 10 at the time of observation and the observed value of the reactance component Zimag, the reactance component Zimag is corrected to a value ZimagA (Tstd) corresponding to an any temperature. The any temperature is, for example, 25°C.

In the fifth step, similarly to the fourth step, the reactance component Zimag is converted to a calculation value ZimagB (Tstd, SOCstd) corresponding to a predetermined SOC based on a linear regression model of the reactance component Zimag at each frequency of the secondary battery 10 acquired in advance and the SOC of the secondary battery 10.

By correcting the reactance component Zimag to a value corresponding to an any temperature and any SOC in the fourth step and the fifth step, model errors can be reduced. In the following steps, the reactance component ZimagB (Tstd, SOCstd) corresponding to any temperature and any SOC is used.

In the sixth step, a predetermined period of time is counted. That is, in the sixth step, it is counted how much time has passed since the reactance component ZimagB was acquired last time. For example, the number of days since the reactance component ZimagB was acquired last time is counted. This is because when the number of data of the reactance component ZimagB is small, the number of data is interpolated in the next seventh step.

In the seventh step, in the predetermined period counted in the sixth step, if the number of days between the N-th unit N and the N+1 unit is large, the data is interpolated using the reactance component ZimagB. In other words, if there is a time interval longer than a certain period between acquiring the reactance component ZimagB last time and acquiring the reactance component ZimagB the present time, the data between the reactance component ZimagB acquired last time and the reactance component ZimagB acquired the present time is interpolated using the already acquired reactance component ZimagB. In other words, the amount of data of the reactance component ZimagB is increased. The predetermined number of days is, for example, 50 days or 100 days. The predetermined number of days may be set as appropriate depending on the amount of data required.

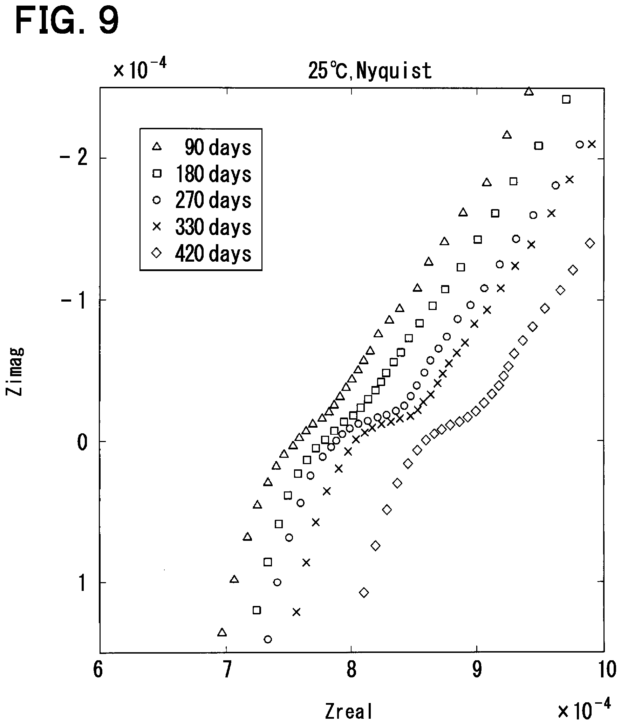

For example, as shown in FIG. 9, the reactance component ZimagB is acquired on the 90th day, 180th day, 270th day, 330th day, and 420th day. Then, the reactance component ZimagB between the 90th day and the 180th day is interpolated using the reactance components ZimagB in the previous and subsequent time series. Similarly, for other units, the data of the reactance component ZimagB is interpolated. The data interpolation is performed by a linear regression model. Since the amount of data for the reactance component ZimagB increases, the accuracy of SOH estimation improves.

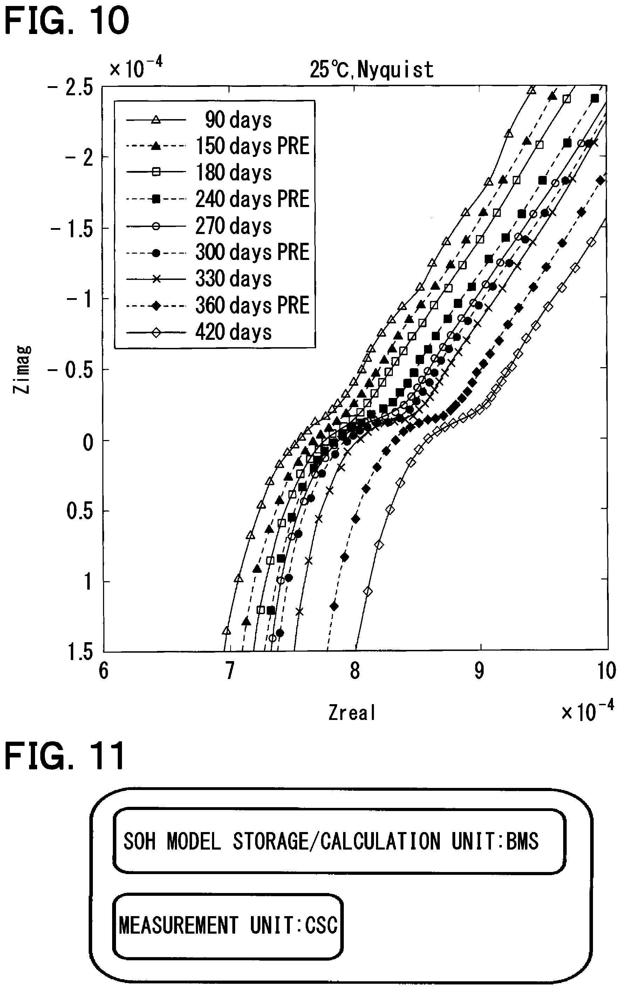

As a result, as shown in FIG. 10, for example, data on the reactance component ZimagB on the 150th day is interpolated between the 90th day and the 180th day. Similarly, for other units, the data of the reactance component ZimagB is interpolated.

In the eighth step, a regression model using the variance-covariance matrix $\Sigma$ is synthesized using the battery capacity as the SOH information periodically measured in the first step and the reactance component ZimagB at a specific frequency as information indicating the battery state that has a correlation with the SOH higher than a predetermined correlation acquired in the third step. The nonlinear model using the variance-covariance matrix $\Sigma$ is based on Gaussian Process Regression (i.e., GPR), which is a machine learning technique.

In the ninth step, the SOH of the secondary battery 10 is estimated using the reactance component ZimagB at the specific frequency acquired from the regression model in the eighth step. If the data of the reactance component ZimagB is not interpolated in the seventh step, the SOH of the secondary battery 10 is estimated based on the data of the reactance component ZimagB acquired up to the fifth step. When the data of the reactance component ZimagB is interpolated in the seventh step, the SOH of the secondary battery 10 is estimated based on the data after interpolation.

The SOH estimation model is built as described above. After this, the SOH estimation model is stored in the storage unit 50. Here, the resistance of the secondary battery 10 measured based on the current may be used as output data for building the SOH estimation model. The resistance includes static resistance and dynamic resistance. As the resistance as the output data, either static resistance or dynamic resistance may be used.

Next, a method for estimating the SOH using the SOH estimation model will be described. As shown in the lower part of FIG. 2, the SOH can be calculated by inputting information indicating the battery state of the secondary battery 10 into the relational expression of the SOH estimation model. That is, the SOH estimation unit 80 estimates the SOH of the secondary battery 10 by inputting information indicating the current battery state of the secondary battery 10 into the SOH estimation model.

The SOH estimation unit 80 uses, as the current measurement value, the actual measurement value of the reactance component Zimag of the complex impedance calculated based on an AC current of a specific frequency that has a high correlation with the SOH of the secondary battery 10. The SOH estimation unit 80 uses the specific frequency f, the SOC, and the temperature T as conditions.

The SOH estimation unit 80 may acquire, fro the calculation unit 70, the data prepared by converting the reactance component Zimag into a calculation value corresponding to a predetermined temperature and a predetermined SOC based on the temperature and the SOC of the secondary battery 10 when the reactance component Zimag is acquired. The SOH estimation unit 80 may calculate the SOH by inputting the data of the reactance component ZimagB of the reference SOC and the reference temperature into the relational expression of the SOH estimation model. This makes it possible to calculate the SOH that is not affected by the SOC and the temperature.

The SOH estimation unit 80 outputs the estimated SOH to the output unit 85. The output unit 85 notifies the user of the acquired SOH, uses the acquired SOH for charge/discharge control of the secondary battery 10, and the like.

As explained above, when estimating the SOH of the secondary battery 10, the reactance component Zimag of the complex impedance Z is calculated based on the alternating current of a specific frequency instead of all frequencies in a certain range. Therefore, the calculation time can be shorter than when calculating the reactance component Zimag corresponding to all frequencies in a certain range. Further, the SOH can be calculated by inputting information indicating the battery state of the secondary battery to the SOH estimation model. Therefore, the time required for diagnosing the SOH of the secondary battery 10 can be shortened.

Furthermore, in order to estimate the SOH of the secondary battery 10, a nonlinear model using a variance-covariance matrix $\Sigma$ is used. Therefore, the accuracy of estimating the deterioration state of the secondary battery 10 can be improved compared to a monotonic linear model. Therefore, the SOH of the secondary battery 10 can be estimated with high accuracy.

As described above, each function of the secondary battery state detection device is configured independently. That is, each function can be appropriately arranged depending on the target to which the secondary battery state detection device is applied.

For example, in the configuration shown in FIG. 1, at least a part other than the SOH model building unit 75 is used while being mounted on a vehicle. Further, the SOH model building unit 75 may be provided outside the mobility vehicle such as an electric vehicle. Specific examples are shown in FIG. 11 to FIG. 15. Here, the specific frequency calculation unit 40 may also be provided outside the mobility vehicle such as an electric vehicle.

As shown in FIG. 11, each function other than the SOH model building unit 75 may be accommodated inside the mobility vehicle. In the example shown in FIG. 11, the measurement unit and the SOH model storage/calculation unit are accommodated in the package of the secondary battery 10. The measurement unit is a cell monitoring circuit (i.e., Cell Supervising Circuit or CSC), and corresponds to, for example, the measurement unit 20 and the impedance generation unit 30. The SOH model storage/calculation unit is a battery management system (i.e., BMS) and corresponds to, for example, the SOC calculation unit 60, the calculation unit 70, the storage unit 50, and the SOH estimation unit 80. The SOC calculation unit 60 and the calculation unit 70 may be disposed in the CSC or the BMS. The output unit 85 may be included in the BMS, or may be provided in the package of the secondary battery 10 .

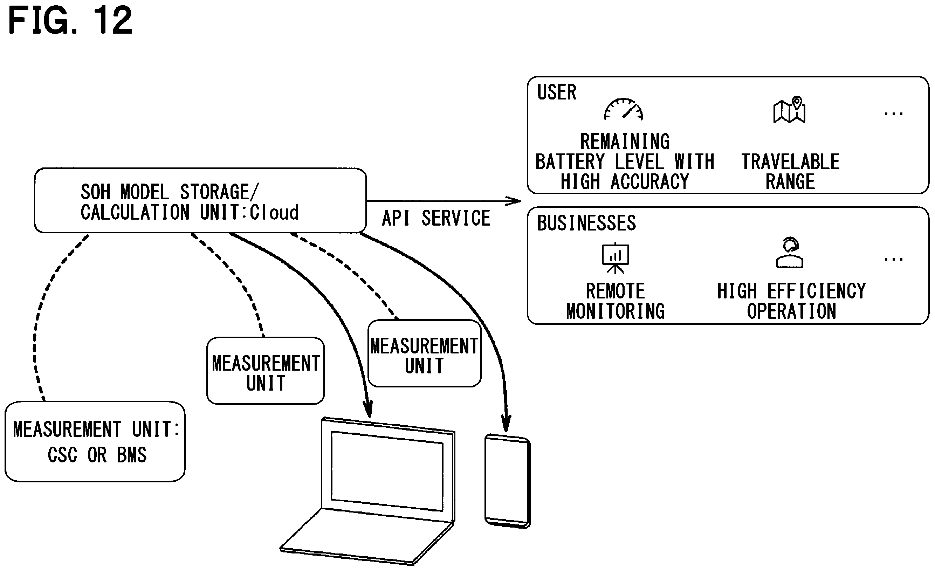

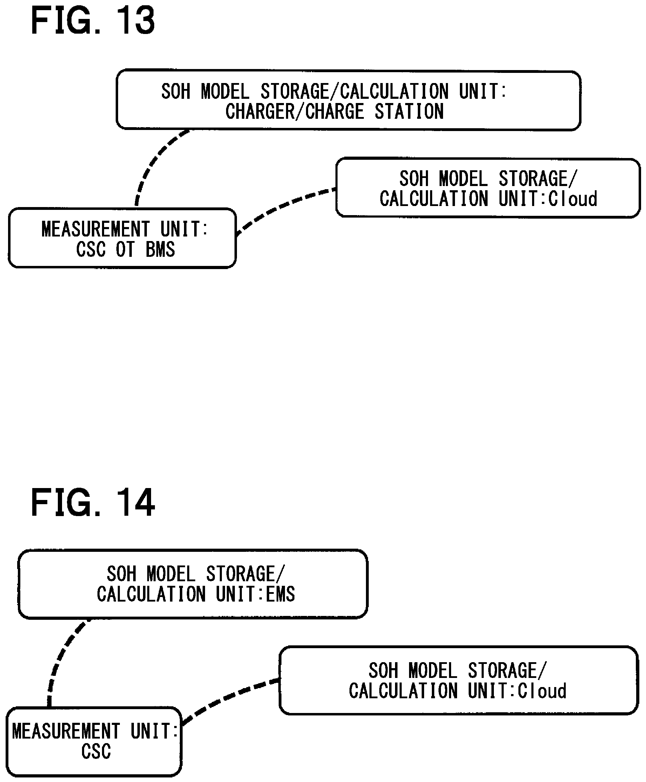

As shown in FIGS. 12 and 13, each function of the secondary battery state detection device may be provided inside and outside the mobility vehicle.

In the example shown in FIG. 12, the measurement unit is configured as a CSC or a BMS and is disposed in the mobility vehicle. The SOH model storage/calculation unit is disposed in the cloud. The output unit 85 is disposed in a personal computer, a tablet, a mobile information terminal, or the like. The SOH calculation results are provided to users and businesses through API services. This makes it possible for the user to know the remaining battery level and the travelable range with high accuracy. The businesses can perform remote monitoring and highly efficient operations.

In the example shown in FIG. 13, an electric vehicle as a mobility vehicle is charged by a charger or at a charging station. In this case, the SOH model storage/calculation unit is disposed in the charger or the charging station. Alternatively, the SOH model storage/calculation unit may be disposed in the cloud.

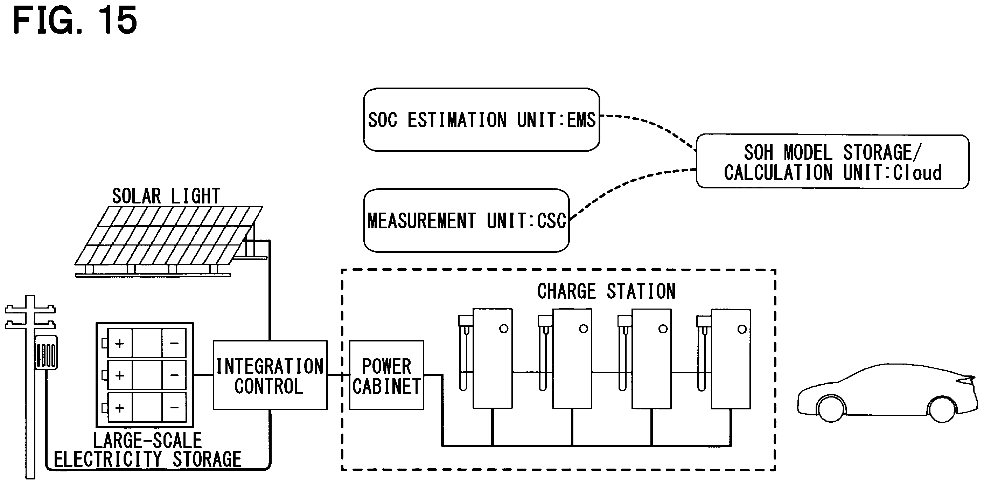

As shown in FIGS. 14 and 15, each function of the secondary battery state detection device may be provided outside the mobility vehicle.

The example shown in FIG. 14 is a case where the secondary battery 10 is separated from the mobility vehicle, for example, in a repair shop or a factory that regenerates recovered batteries. In this case, the measurement unit (i.e., the CSC) is configured as a measurement device. The SOH model storage/calculation unit is configured as an energy management system (i.e., EMS). Alternatively, the SOH model storage/calculation unit may be disposed in the cloud. The output unit 85 may be provided in the measurement unit 20 or may be arranged in another electronic device.

The example in FIG. 15 is a case where the secondary battery state detection device is applied to a quick charging system. The quick charging system uses an integration control facility to control for storing the electricity generated by solar power generation or from power lines in a large-scale power storage facility, and charges the electricity into the secondary battery 10 of the mobility vehicle via a power cabinet and a charging station. In this case, the measurement unit is provided in the charging station. The SOH model storage/calculation unit corresponds to, for example, the storage unit 50, the SOC calculation unit 60, and the calculation unit 70, and is disposed in the cloud. The SOH estimation unit 80 is provided in the EMS. The SOH estimation unit 80 may be provided in the cloud. The output unit 85 is provided in a mobility vehicle or a user's electronic device. The output unit 85 may be provided in the EMS.

Here, the measurement unit 20, the impedance generation device 30, the SOC calculation unit 60, and the calculation unit 70 of this embodiment correspond to the "detection unit". The SOH model building unit 75 corresponds to a "learning unit." The SOH estimation unit 80 corresponds to the "calculation unit".

Further, the means executed by the measurement unit 20, the impedance generation device 30, the SOC calculation unit 60, and the calculation unit 70 correspond to the "first step". The means executed by the impedance generation unit 30, the SOC calculation unit 60, and the calculation unit 70 correspond to the "second step." The means executed by the SOH model building unit 75 corresponds to the "third step". Furthermore, the means executed by the SOH estimation unit 80 corresponds to the "fourth step".

(Second Embodiment)

In the present embodiment, portions different from those of the first embodiment will be mainly described. In this embodiment, the learning data is increased using market data acquired after the start of operation of the secondary battery state detection device, the SOH estimation model is rebuilt using the learning data added thereon, and the SOH estimation model to be used in the SOH estimation unit 80 is updated.

The market data is data that is accumulated as the secondary battery 10 is actually used. That is, the market data is data on actual measurement impedance characteristics and battery capacity when the secondary battery 10 is used. The actual measurement impedance characteristics include data on the reactance component Zimag of the complex impedance, the specific frequency, the temperature, and the SOC.

Here, the battery capacity data may be not only an actual value measured using a charger but also a calculated value using a model or the like. Further, instead of the market data, data on impedance characteristics and battery capacity acquired in a laboratory or the like may be used as the learning data. In this case, n-increase evaluation or the like may be adopted. The data acquired in a laboratory or the like is also data acquired when the secondary battery 10 is actually used. Instead of battery capacity data, resistance data may be used.

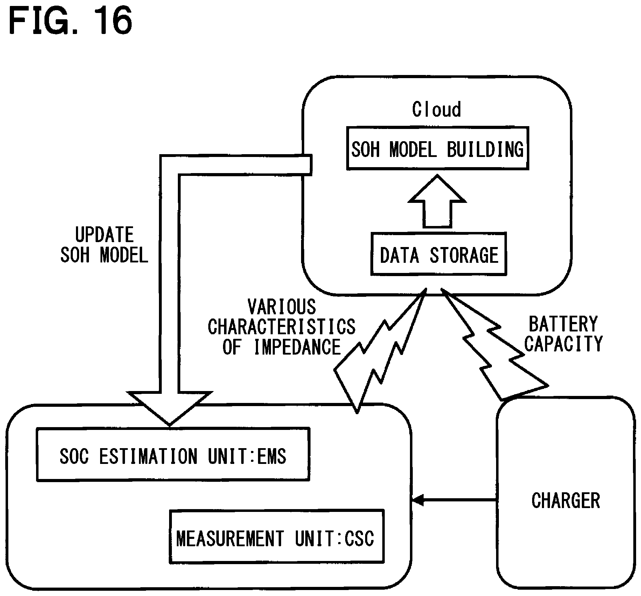

For example, as shown in FIG. 16, the battery capacity is actually measured based on the amount of charge in the charger. The battery capacity data is transmitted from the charger to the cloud and is also stored in the cloud. On the other hand, each data of impedance characteristics is transmitted to the cloud from the measurement unit (i.e., the CSC) and the SOH estimation unit 80 (i.e., the BMS) mounted on the electric vehicle, and is also stored in the cloud.

In the cloud, the SOH model building unit 75 rebuilds the SOH estimation model based on each data of impedance characteristics and battery capacity. The rebuilt SOH estimation model is stored in the storage unit 50, thereby updating the SOH estimation model in the storage unit 50 to the latest model. Since the storage unit 50 is independent from each component, by replacing the storage unit 50 of the electric vehicle, the latest SOH estimation model can be used in the electric vehicle.

Alternatively, the SOH estimation model stored in the storage unit 50 may be updated using communication such as OTA (i.e., Over the Air). This makes it possible to update the data in the storage unit 50 without replacing the storage unit 50 itself.

(Third Embodiment)

In the present embodiment, portions different from those of the first and second embodiments will be mainly described. In this embodiment, data different from the reactance component Zimag of complex impedance is used as input data for building the SOH estimation model.

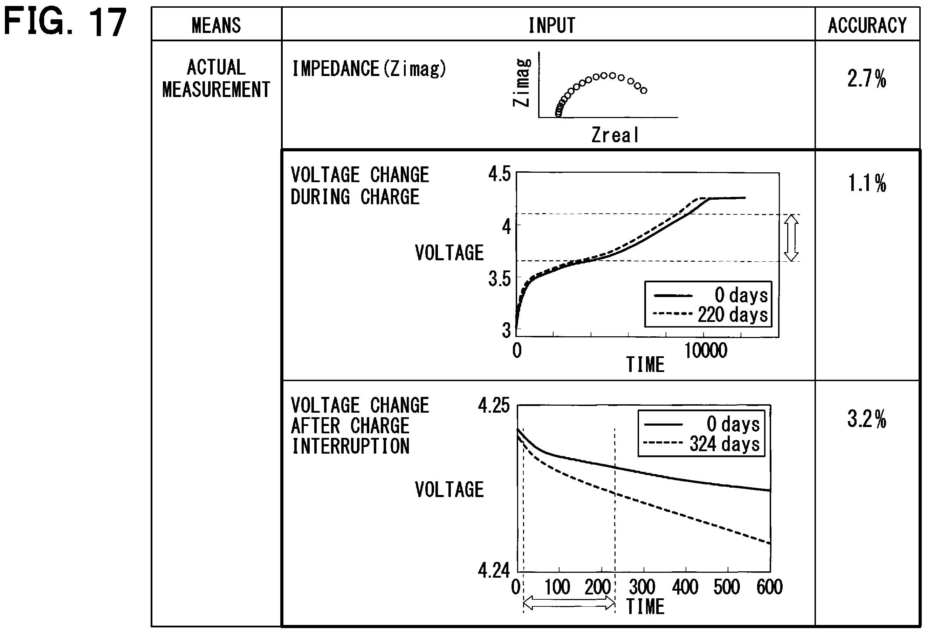

As shown in the middle part of FIG. 17, the voltage during charging increases over time. Further, the charging voltage curve changes depending on the deterioration of the secondary battery 10. Therefore, the charging time, the voltage, and the temperature between predetermined voltages when charging the secondary battery 10 can be used as input data for learning data. These data are information indicating the battery state that has a correlation with SOH higher than a predetermined correlation.

Moreover, as shown in the lower part of FIG. 17, the voltage after the charge interruption is decreased with time. Further, the voltage transition curve changes depending on the deterioration of the secondary battery 10. Therefore, the interruption time, the voltage, and the temperature during the predetermined interruption time after charging the secondary battery 10 can be used as input data for learning data. These data are information indicating the battery state that has a correlation with SOH higher than a predetermined correlation.

For example, when an NCM-based positive electrode active material is used as the secondary battery 10, the estimation accuracy of SOH has the error of 2.7% in the case of impedance, the error of 1.1% in the case of voltage change during charging, and the error of 3.2% in the case of the voltage change after the charge interruption. There was no difference in error for each input data. Therefore, any data may be used as information indicating a battery state having the correlation with the SOH higher than a predetermined correlation.

When the voltage change during charging and the voltage change after the charge interruption are used as input data, a device or a circuit for measuring the impedance of the secondary battery 10 becomes unnecessary. Therefore, since it is possible to estimate the SOH by using a measurement unit and a calculation unit, it is possible to improve the designing degree of freedom in mounting the secondary battery state detection device on the mounting target. In this case, for example, it is also possible to incorporate a secondary battery state detection device into the charger.

(Fourth Embodiment)

In the present embodiment, the configurations different from the respective embodiments described above will be described. In this embodiment, the use of the SOH estimation results calculated by the SOH estimation model will be described.

First, the battery control parameters of the secondary battery 10 can be updated based on the SOH estimation result. The battery control can be utilized, for example, for charge control.

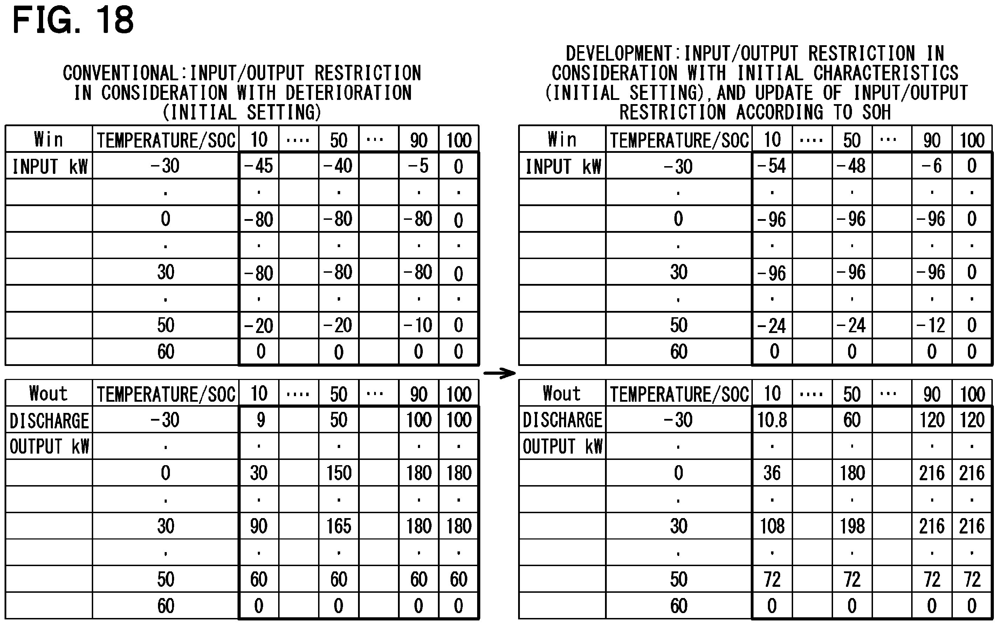

As shown on the left side of FIG. 18, conventionally, the input and output of the secondary battery 10 has been restricted as an initial setting in consideration of deterioration of the secondary battery 10. The input (i.e., Win) and output (i.e., Wout) of the secondary battery 10 are controlled by each value shown in the temperature and SOC map. Each numerical value is preset to a small value taking into consideration deterioration of the secondary battery 10 . The input/output restriction parameters are stored in the BMU, for example.

On the other hand, as shown on the right side of FIG. 18, the input/output restriction parameters of the BMU can be updated based on the SOH estimation results. Specifically, each numerical value of the temperature and SOC maps is updated to a value higher than the initial value. Here, when using the reactance component Zimag of the complex impedance as the input data of the learning data, the input/output restriction of the secondary battery 10 may be updated according to fluctuations in the SOH and the impedance (or the resistance).

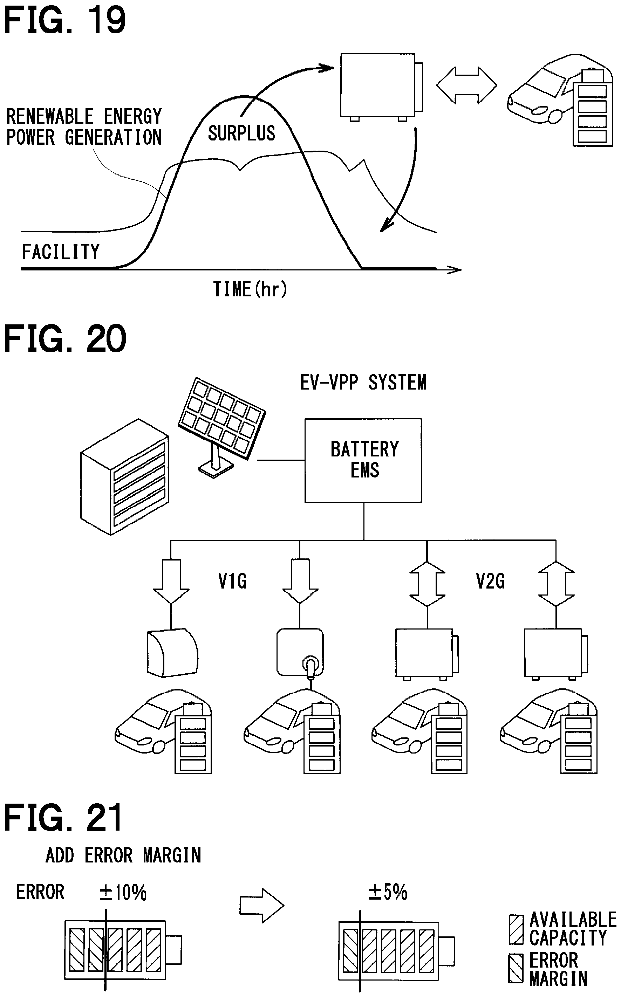

Another battery control can be utilized, for example, for charge/discharge control. As the charge/discharge control, it can be applied to the EV - VPP (i.e., Virtual Power Plant) system shown in FIGS. 19 and 20.

In the example shown in FIG. 19, in the case of renewable energy power generation using sunlight, the amount of power generation is concentrated in the daytime and exceeds the amount of power used in the facility. Therefore, the excess power generated during the daytime is charged to the secondary battery 10 of the electric vehicle or a stationary secondary battery, and the power from the secondary battery 10 is used in the facility at night when the amount of power generated by renewable energy power generation decreases. In this way, by shifting the excess power of renewable energy power generation to the secondary battery 10 and using up the excess power, it is possible to reduce $CO_2$ emissions and electricity costs.

As shown in FIG. 21, conventionally, an error margin was added to the SOH, so the error of the SOH was, for example, $\pm$ 10%. However, the usable amount of the secondary battery 10 can be varied depending on the SOH estimation result. For example, the SOH error of the secondary battery 10 is reduced to, for example, $\pm$ 5%. In this way, the error margin of the secondary battery 10 can be minimized, and the usable capacity can be increased.

In the example shown in FIG. 20, charging and discharging of the secondary battery 10 can be managed in the battery EMS. In this case, a V1G method that allows charging or a V2G method that allows charging and discharging is used. Similarly to the above, since the usable capacity of the secondary battery 10 increases, the high efficiency range of the charger/discharger can be utilized. Therefore, the power of the secondary battery 10 can be used efficiently.

The SOH estimation result of the secondary battery 10 can be used for the secondary battery 10 separated from the device or the facility in which the secondary battery 10 is to be used. In this case, the secondary battery 10 is, for example, a replacement battery for an electric vehicle.

For example, when selling a new car, an electric vehicle can be priced without a battery, and the insurance interest rate can be changed depending on the subsequent SOH estimation result. At the time of replacing a battery to a new battery, partial maintenance can be performed on the secondary battery 10 instead of the entire secondary battery 10 according to the SOH estimation result. When reusing the secondary battery 10, the secondary usage destination can be determined according to the SOH estimation result.

The secondary battery 10 can be replaced in a short time since the secondary battery 10 has already been charged. At the time of replacement, the charging time and the battery pack can be selected depending on the usage and the purpose of the secondary battery 10. The battery pack is a secondary battery 10. As for places to replace, it is possible to replace at a convenience store, or the like for a private use. The combination of battery packs can be determined depending on the SOH error. In used car sales, there is no need for battery assessment. Residual value can be determined based on the SOH estimation results.

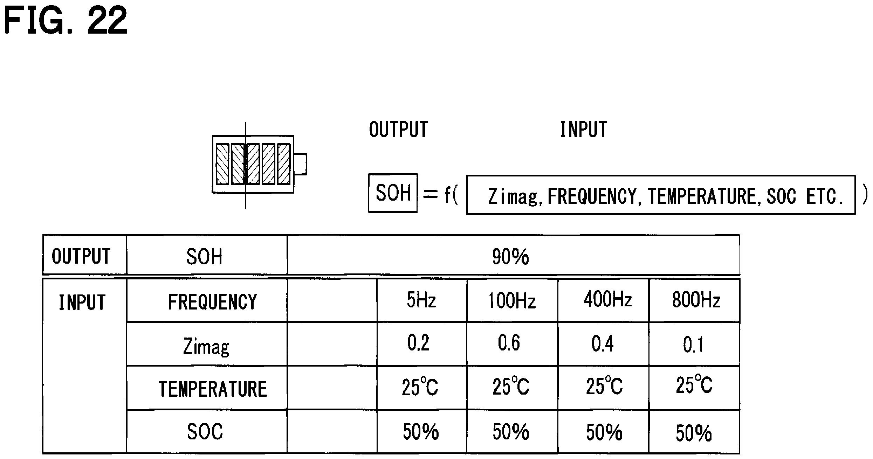

The SOH estimation result of the secondary battery 10 can be used for authentication of the battery pack. As shown in FIG. 22, input data and output data for estimating the SOH are combined and used for battery pack/vehicle authentication.

That is, the history of deterioration of the secondary battery 10 is encrypted and used. Even if the calculated SOH values are the same, the deterioration history is different, so it can be determined that the battery packs are different.

The example shown in FIG. 22 is a case where the reactance component Zimag of the complex impedance is used. Similarly, in the case of a voltage change during charging or a voltage change after charge interruption, authentication can be performed using the history of deterioration of the secondary battery 10.

The present disclosure is not limited to the embodiments described above, and various modifications can be made as follows within a range not departing from the spirit of the present disclosure.

For example, the secondary battery 10 is not limited to a case of being mounted on an electric vehicle, and may include a case of being disposed at a predetermined place. Further, the SOH of the secondary battery 10 is not limited to the SOH of the entire secondary battery 10, and may be the SOH of a single battery cell or a plurality of SOHs of the battery cells that constitute the secondary battery 10.

The SOH model building unit 75 may be configured alone as a learning unit that builds an SOH estimation model for estimating the SOH.

The secondary battery state detection device can perform storage, calculation, and estimation in system link via a server or the like. In other words, each component of the secondary battery state detection device may be arranged in a distributed manner. On the other hand, the secondary battery state detection device may be configured to be provided completely within one device by arranging other components around the secondary battery 10. Further, the secondary battery 10 can be reused. Therefore, when reusing the secondary battery 10 is considered, components other than the secondary battery 10 may be functionally arranged in the reused secondary battery 10. That is, the detection device for the secondary battery state may be configured by rebuilding the reused secondary battery 10 and other components such as the SOH estimation unit 80. In this case, as described above, the detection device for the secondary battery state may have a system-linked configuration or may be a complete configuration within one device.

Although the present disclosure has been made in accordance with the embodiments, it is understood that the present disclosure is not limited to such embodiments and structures. The present disclosure incorporates various modifications and variations within the scope of equivalents. In addition, various combinations and forms, and other combinations and forms including only one element, more, or less than them are also included in the scope and concept of the present disclosure.

**Claims**

1. A secondary battery state detection device that estimates an SOH indicating a degree of deterioration of a secondary battery (10), the secondary battery state detection device comprising:

    a detection unit (20, 30, 60, 70) that detects information indicating a battery state of the secondary battery;
    a learning unit (75) that learns an SOH estimation model for estimating the SOH;
    a storage unit (50) that stores the SOH estimation model;
    a calculation unit (80) that calculates the SOH using information indicating the battery state of the secondary battery detected by the detection unit and the SOH estimation model stored in the storage unit; and
    an output unit (85) that outputs an estimation result of the SOH acquired by the calculation unit, wherein:

    SOH information and information indicating the battery state having a correlation with the SOH higher than a predetermined correlation among the information indicating the battery state of the secondary battery are defined as learning data;
    the SOH information is defined as output;
    the information indicating the battery state having the correlation with the SOH higher than the predetermined correlation is defined as input; and
    the SOH estimation model learned by the learning unit is built by synthesizing a regression model using a variance-covariance matrix.

2. The secondary battery state detection device according to claim 1, wherein:
   in the variance-covariance matrix, the information indicating the battery state having the correlation with the SOH higher than the predetermined correlation is expressed using a kernel function.

3. The secondary battery state detection device according to claim 1 or 2, wherein:
   when synthesizing the regression model using the variance-covariance matrix, in a case where a time interval exists between when the information indicating the battery state having the correlated with the SOH higher than the predetermined correlation was acquired last time and when the information indicating the battery state having the correlated with the SOH higher than the predetermined correlation is acquired a present time, the learning unit interpolates between the information indicating the battery state having the correlated with the SOH higher than the predetermined correlation acquired last time and the information indicating the battery state having the correlated with the SOH higher than the predetermined correlation acquired the present time, using the information indicating the battery state having the correlated with the SOH higher than the predetermined correlation already acquired; and the learning unit uses data after interpolation as the input.

4. The secondary battery state detection device according to any one of claims 1 to 3, wherein:
   the SOH information is a battery capacity or a resistance of the secondary battery measured based on current.

5. The secondary battery state detection device according to any one of claims 1 to 4, wherein:

the information indicating the battery state having the correlation with the SOH higher than the predetermined correlation is
a reactance component of a complex impedance calculated based on an alternating current of a specific frequency that has a correlation with the SOH of the secondary battery higher than a predetermined correlation, the specific frequency, SOC, and temperature, or
charging time, voltage, and temperature between predetermined voltages when charging the secondary battery, or
an interruption time interval, voltage, and temperature in a predetermined interruption time after charging the secondary battery.

6. The secondary battery state detection device according to any one of claims 1 to 5, wherein:

the detection unit acquires, as information indicating the battery state of the secondary battery, a reactance component of a complex impedance calculated based on temperature and SOC of the secondary battery and an alternating current of a specific frequency that has a correlation with the SOC higher than a predetermined correlation;
the calculation unit converts the reactance component into a calculation value corresponding to a predetermined temperature and a predetermined SOC based on the temperature and the SOC of the secondary battery when the reactance component is acquired; and
the calculation unit calculates the SOH based on the calculation value and the SOH estimation model.

7. The secondary battery state detection device according to claim 6, wherein:
the calculation unit converts into the calculation value based on a linear model of the reactance component at each frequency of the secondary battery acquired in advance, and the temperature and the SOC of the secondary battery.

8. The secondary battery state detection device according to any one of claims 1 to 7, wherein:
the detection unit, the learning unit, the storage unit, the calculation unit, and the output unit are each independently configured.

9. The secondary battery state detection device according to any one of claims 1 to 8, wherein:

at least a part of units other than the learning unit is mounted on a vehicle; and
the learning unit is provided outside the vehicle.

10. The secondary battery state detection device according to any one of claims 1 to 9, wherein:
the learning unit updates the SOH estimation model stored in the storage unit.

11. The secondary battery state detection device according to claim 10, wherein:
the learning unit uses information indicating the battery state of the secondary battery acquired by the detection unit when the secondary battery is actually used as the learning data for updating the SOH estimation model.

12. The secondary battery state detection device according to any one of claims 1 to 11, wherein:
a battery control parameter of the secondary battery is updated based on an estimation result of the SOH output from the calculation unit.

13. A learning unit that is applied to a secondary battery state detection device for estimating an SOH indicating a degree of deterioration of a secondary battery (10), and that builds an SOH estimation model for estimating the SOH,

SOH information and information indicating the battery state having a correlation with the SOH higher than a predetermined correlation among the information indicating the battery state of the secondary battery are defined as learning data;
the SOH information is defined as output;
the information indicating the battery state having the correlation with the SOH higher than the predetermined correlation is defined as input; and
the learning unit builds the SOH estimation model by synthesizing a regression model using a variance-covariance matrix.

14. The learning unit according to claim 13, wherein:

in the variance-covariance matrix, the information indicating the battery state having the correlation with the SOH higher than the predetermined correlation is expressed using a kernel function.

15. The learning unit according to claim 13 or 14, wherein:
when synthesizing the regression model using the variance-covariance matrix, in a case where a time interval exists between when the information indicating the battery state having the correlated with the SOH higher than the predetermined correlation was acquired last time and when the information indicating the battery state having the correlated with the SOH higher than the predetermined correlation is acquired a present time, the learning unit interpolates between the information indicating the battery state having the correlated with the SOH higher than the predetermined correlation acquired last time and the information indicating the battery state having the correlated with the SOH higher than the predetermined correlation acquired the present time, using the information indicating the battery state having the correlated with the SOH higher than the predetermined correlation already acquired; and the learning unit uses data after interpolation as input.

16. The learning unit according to any one of claims 13 to 15, wherein:
the SOH information is a battery capacity or a resistance of the secondary battery measured based on current.

17. The learning unit according to any one of claims 13 to 16, wherein:

the information indicating the battery state having the correlation with the SOH higher than the predetermined correlation is
a reactance component of a complex impedance calculated based on an alternating current of a specific frequency that has a correlation with the SOH of the secondary battery higher than a predetermined correlation, the specific frequency, SOC, and temperature, or
charging time, voltage, and temperature between predetermined voltages when charging the secondary battery, or
an interruption time interval, voltage, and temperature in a predetermined interruption time after charging the secondary battery.

18. The learning unit according to any one of claims 13 to 17, wherein:
the learning unit updates the SOH estimation model.

19. The learning unit according to claim 18, wherein:
the learning unit uses information indicating the battery state of the secondary battery acquired by actually using the secondary battery as the learning data for updating the SOH estimation model.

20. A secondary battery state detection method for estimating a SOH indicating a degree of deterioration of a secondary battery, comprising:

a first step of acquiring SOH information of the secondary battery;
a second step of acquiring information indicating a battery state of the secondary battery, and acquiring information indicating the battery state having a correlation with the SOH higher than a predetermined correlation among the information indicating the battery state of the secondary battery;
a third step of building a SOH estimation model by synthesizing a regression model using a variance-covariance matrix, in which the SOH information acquired in the first step is defined as an output, and the information indicating the battery state that has the correlation with the SOH higher than the predetermined correlation acquired in the second step is defined as an input; and
a fourth step of estimating the SOH of the secondary battery by inputting information indicating a current battery state of the secondary battery into the SOH estimation model built in the third step.

21. The secondary battery state detection method according to claim 20, wherein:
in the third step, the information indicating the battery state that has the correlation with the SOH higher than the predetermined correlation in the variance-covariance matrix is expressed using a kernel function.

22. The secondary battery state detection method according to claim 20 or 21, wherein:

in the third step, when synthesizing the regression model using the variance-covariance matrix, in a case where a time interval exists between when the information indicating the battery state having the correlated with the SOH higher than the predetermined correlation was acquired last time and when the information indicating the battery state having the correlated with the SOH higher than the predetermined correlation is acquired a present time, data is interpolated between the information indicating the battery state having the correlated with the SOH higher than the predetermined correlation acquired last time and the information indicating the battery state having the correlated with the SOH higher than the predetermined correlation acquired the present time, using the information indicating the battery state having the correlated with the SOH higher than the predetermined correlation already acquired; and

in the third step, data after interpolation is used as the input.

23. The secondary battery state detection method according to any one of claims 20 to 22, wherein:
in the first step, a battery capacity or a resistance of the secondary battery measured based on current is acquired as the SOH information.

24. The secondary battery state detection method according to any one of claims 20 to 23, wherein:

in the second step, as the information indicating the battery state that has the correlation higher than the predetermined correlation,
a reactance component of a complex impedance calculated based on an alternating current of a specific frequency that has a correlation with the SOH of the secondary battery higher than a predetermined correlation, the specific frequency, SOC, and temperature, or
charging time, voltage, and temperature between predetermined voltages when charging the secondary battery, or
an interruption time interval, voltage, and temperature in a predetermined interruption time after charging the secondary battery is acquired.

25. The secondary battery state detection method according to any one of claims 20 to 24, wherein:

in the fourth step, as information indicating the battery state of the secondary battery, a reactance component of a complex impedance is acquired and calculated based on temperature and SOC of the secondary battery and an alternating current of a specific frequency that has a correlation with the SOC higher than a predetermined correlation;
in the fourth step, the reactance component is converted into a calculation value corresponding to a predetermined temperature and a predetermined SOC based on the temperature and the SOC of the secondary battery when the reactance component is acquired; and
in the fourth step, the SOH is estimated based on the calculation value and the SOH estimation model.

26. The secondary battery state detection method according to claim 25, wherein:
in the fourth step, the calculation value is calculated based on a linear model of the reactance component at each frequency of the secondary battery acquired in advance, and the temperature and the SOC of the secondary battery.

27. The secondary battery state detection method according to any one of claims 20 to 26, wherein:
in the third step, the SOH estimation model is updated.

28. The secondary battery state detection method according to claim 27, wherein:
information indicating the battery state of the secondary battery acquired by actually using the secondary battery is used as learning data for updating the SOH estimation model.

FIG. 1

FIG. 2

SOH MODEL BUILDING UNIT

LEARNING DATA

CAPACITY ESTIMATION
(ACTUAL MEASUREMENT) SOH

MODEL BUILDING

IMPEDANCE (ACTUAL MEASUREMENT)

Zimag

Zreal

SOH MODEL
BUILDING

MEASUREMENT UNIT

ACQUIRE CHARACTERISTIC
OF TARGET CELL

●IMPEDANCE
:Zimag, TEMPERATURE T, SOC AND f
SPECIFIC FREQUENCY
REGION f

Zimag

Zreal

SOH ESTIMATION

MEASUREMENT VALUE:Zimag
CONDITION:f, T AND SOC

SOH MODEL

ESTIMATE
SOH

INPUT

SOH ESTIMATION UNIT

OUTPUT

EP 4 478 068 A1

# FIG. 3

# FIG. 4

# FIG. 5

# FIG. 6

# FIG. 7

```
┌─────────────────────────────────┐
│   MEASUREMENT (I, V, T, t) AND MEMORY │
│          MEASURE BATTERY         │
│        CAPACITY PERIODICALLY     │
└─────────────────────────────────┘
                 │
                 ▼
┌─────────────────────────────────┐
│            COUNT                 │
│       PREDETERMINED TIME         │
└─────────────────────────────────┘
                 │
                 ▼
┌───────────────────────────────────────────────┐
│      MEASUREMENT (I, V, T, t) AND MEMORY        │
│  CALCULATE COMPLEX IMPEDANCE AT SPECIFIC FREQUENCY, │
│    AND EXTRACT REACTANCE COMPONENT Zimag        │
│         AT EACH SPECIFIC FREQUENCY              │
└───────────────────────────────────────────────┘
                 │
                 ▼
┌─────────────────────────────────┐
│  CORRECT Zimag AT ANY TEMPERATURE │
│    BASED ON TEMPERATURE DATA     │
│    IN PREDETERMINED SECTION N    │
│     ZimagA(Tstd)=f(Zimag, T)     │
└─────────────────────────────────┘
                 │
                 ▼
┌─────────────────────────────────────────┐
│     CORRECT Zimag AT ANY SOC BASED ON     │
│  SOC DATA IN PREDETERMINED SECTION N     │
│    ZimagB(Tstd, SOCstd)=f(ZimagA, SOC)   │
└─────────────────────────────────────────┘
                 │
                 ▼
┌─────────────────────────────────┐
│     COUNT PREDETERMINED          │◄──────┐
│          PERIOD                  │       │
└─────────────────────────────────┘       │
                 │                         │
                 ▼                         │
┌─────────────────────────────────┐       │
│  INTERPOLATE ZimagB (Tstd, SOCstd) │      │
│     BETWEEN PREDETERMINED         │      │
│     SECTIONS FROM N TO N+1        │      │
└─────────────────────────────────┘       │
                 │                         │
                 ▼                         │
┌───────────────────────────────────────────────┐ │
│       SYNTHESIZE REGRESSION MODEL USING         │ │
│  VARIANCE-COVARIANCE MATRIX ACCORDING TO ZimagB │ │
│   AT SPECIFIC FREQUENCY WITH BATTERY CAPACITY   │ │
└───────────────────────────────────────────────┘ │
                 │                         │
                 ▼                         │
┌───────────────────────────────────────────────┐ │
│  ESTIMATE SOH USING ZimagB AT SPECIFIC FREQUENCY │◄┘
│      ACQUIRED BY REGRESSION MODEL               │
└───────────────────────────────────────────────┘
```

# FIG. 8

# FIG. 9

## FIG. 10

25℃,Nyquist

Legend:
- 90 days
- 150 days PRE
- 180 days
- 240 days PRE
- 270 days
- 300 days PRE
- 330 days
- 360 days PRE
- 420 days

Y-axis: Zimag ($\times 10^{-4}$): $-2.5$, $-2$, $-1.5$, $-1$, $-0.5$, $0$, $0.5$, $1$, $1.5$

X-axis: Zreal: $6$, $7$, $8$, $9$, $10$ $\times 10^{-4}$

## FIG. 11

SOH MODEL STORAGE/CALCULATION UNIT:BMS

MEASUREMENT UNIT:CSC

# FIG. 12

SOH MODEL STORAGE/
CALCULATION UNIT:Cloud

API SERVICE

USER

REMAINING
BATTERY LEVEL WITH
HIGH ACCURACY

TRAVELABLE
RANGE

· · ·

BUSINESSES

REMOTE
MONITORING

HIGH EFFICIENCY
OPERATION

· · ·

MEASUREMENT UNIT:
CSC OR BMS

MEASUREMENT
UNIT

MEASUREMENT
UNIT

EP 4 478 068 A1

# FIG. 13

```
┌─────────────────────────────────────────┐
│  SOH MODEL STORAGE/CALCULATION UNIT:     │
│         CHARGER/CHARGE STATION           │
└─────────────────────────────────────────┘

                          ┌──────────────────────────┐
                          │   SOH MODEL STORAGE/      │
                          │ CALCULATION UNIT:Cloud     │
                          └──────────────────────────┘
┌─────────────────────────┐
│   MEASUREMENT UNIT:      │
│       CSC OT BMS         │
└─────────────────────────┘
```

# FIG. 14

```
┌──────────────────────────┐
│   SOH MODEL STORAGE/      │
│ CALCULATION UNIT:EMS      │
└──────────────────────────┘

                          ┌──────────────────────────┐
                          │   SOH MODEL STORAGE/      │
                          │ CALCULATION UNIT:Cloud    │
                          └──────────────────────────┘
┌──────────────────────────┐
│  MEASUREMENT UNIT:        │
│        CSC                │
└──────────────────────────┘
```

# FIG. 15

SOC ESTIMATION UNIT:EMS

SOH MODEL STORAGE/
CALCULATION UNIT:Cloud

MEASUREMENT UNIT:CSC

SOLAR LIGHT

CHARGE STATION

INTEGRATION
CONTROL

POWER
CABINET

LARGE-SCALE
ELECTRICITY STORAGE

EP 4 478 068 A1

# FIG. 16

Cloud

SOH MODEL BUILDING

DATA STORAGE

UPDATE
SOH MODEL

VARIOUS
CHARACTERISTICS
OF IMPEDANCE

BATTERY
CAPACITY

SOC ESTIMATION UNIT:EMS

MEASUREMENT UNIT:CSC

CHARGER

# FIG. 17

| MEANS | INPUT | ACCURACY |
|---|---|---|
| ACTUAL MEASUREMENT | IMPEDANCE (Zimag) | 2.7% |
| | VOLTAGE CHANGE DURING CHARGE | 1.1% |
| | VOLTAGE CHANGE AFTER CHARGE INTERRUPTION | 3.2% |

EP 4 478 068 A1

# FIG. 18

CONVENTIONAL:INPUT/OUTPUT RESTRICTION IN CONSIDERATION WITH DETERIORATION (INITIAL SETTING)

| Win | TEMPERATURE/SOC | 10 | .... | 50 | ... | 90 | 100 |
|---|---|---|---|---|---|---|---|
| INPUT kW | −30 | −45 | | −40 | | −5 | 0 |
| | . | . | | . | | . | . |
| | 0 | −80 | | −80 | | −80 | 0 |
| | . | . | | . | | . | . |
| | 30 | −80 | | −80 | | −80 | 0 |
| | . | . | | . | | . | . |
| | 50 | −20 | | −20 | | −10 | 0 |
| | 60 | 0 | | 0 | | 0 | 0 |

| Wout | TEMPERATURE/SOC | 10 | .... | 50 | ... | 90 | 100 |
|---|---|---|---|---|---|---|---|
| DISCHARGE OUTPUT kW | −30 | 9 | | 50 | | 100 | 100 |
| | . | . | | . | | . | . |
| | 0 | 30 | | 150 | | 180 | 180 |
| | . | . | | . | | . | . |
| | 30 | 90 | | 165 | | 180 | 180 |
| | . | . | | . | | . | . |
| | 50 | 60 | | 60 | | 60 | 60 |
| | 60 | 0 | | 0 | | 0 | 0 |

DEVELOPMENT:INPUT/OUTPUT RESTRICTION IN CONSIDERATION WITH INITIAL CHARACTERISTICS (INITIAL SETTING),AND UPDATE OF INPUT/OUTPUT RESTRICTION ACCORDING TO SOH

| Win | TEMPERATURE/SOC | 10 | .... | 50 | ... | 90 | 100 |
|---|---|---|---|---|---|---|---|
| INPUT kW | −30 | −54 | | −48 | | −6 | 0 |
| | . | . | | . | | . | . |
| | 0 | −96 | | −96 | | −96 | 0 |
| | . | . | | . | | . | . |
| | 30 | −96 | | −96 | | −96 | 0 |
| | . | . | | . | | . | . |
| | 50 | −24 | | −24 | | −12 | 0 |
| | 60 | 0 | | 0 | | 0 | 0 |

| Wout | TEMPERATURE/SOC | 10 | .... | 50 | ... | 90 | 100 |
|---|---|---|---|---|---|---|---|
| DISCHARGE OUTPUT kW | −30 | 10.8 | | 60 | | 120 | 120 |
| | . | . | | . | | . | . |
| | 0 | 36 | | 180 | | 216 | 216 |
| | . | . | | . | | . | . |
| | 30 | 108 | | 198 | | 216 | 216 |
| | . | . | | . | | . | . |
| | 50 | 72 | | 72 | | 72 | 72 |
| | 60 | 0 | | 0 | | 0 | 0 |

EP 4 478 068 A1

# FIG. 19

RENEWABLE ENERGY
POWER GENERATION

SURPLUS

FACILITY

TIME(hr)

# FIG. 20

EV-VPP SYSTEM

BATTERY
EMS

V1G

V2G

# FIG. 21

ADD ERROR MARGIN

ERROR    ±10%    ⇨    ±5%

AVAILABLE
CAPACITY

ERROR
MARGIN

# FIG. 22

OUTPUT　　　　　　　　　INPUT

$\boxed{\text{SOH}} = f(\boxed{\text{Zimag, FREQUENCY, TEMPERATURE, SOC ETC.}}$ )

| OUTPUT | SOH | 90% | | | | |
|--------|-----|-----|-----|-----|-----|-----|
| INPUT | FREQUENCY | | 5Hz | 100Hz | 400Hz | 800Hz |
| | Zimag | | 0.2 | 0.6 | 0.4 | 0.1 |
| | TEMPERATURE | | 25°C | 25°C | 25°C | 25°C |
| | SOC | | 50% | 50% | 50% | 50% |

EP 4 478 068 A1

## INTERNATIONAL SEARCH REPORT

| International application No. |
|---|
| **PCT/JP2022/035710** |

### A. CLASSIFICATION OF SUBJECT MATTER

*G01R 31/392*(2019.01)i; *G01R 31/367*(2019.01)i; *G01R 31/389*(2019.01)i; *H01M 10/42*(2006.01)i; *H01M 10/48*(2006.01)i; *H02J 7/00*(2006.01)i

FI:    G01R31/392; G01R31/367; H01M10/42 P; H01M10/48 P; H01M10/48 301; H02J7/00 Q; G01R31/389

According to International Patent Classification (IPC) or to both national classification and IPC

### B. FIELDS SEARCHED

Minimum documentation searched (classification system followed by classification symbols)

G01R31/392; G01R31/367; G01R31/389; H01M10/42; H01M10/48; H02J7/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2016-90346 A (ENNET CO LTD) 23 May 2016 (2016-05-23) paragraphs [0001]-[0004], [0028]-[0083], fig. 1-6 | 1-4, 8-11, 13-16, 18-23, 27-28 |
| Y | | 12 |
| A | | 5-7, 17, 24-26 |
| Y | WO 2021/044132 A1 (SIEMENS PLC) 11 March 2021 (2021-03-11) column 1, lines 6-7, column 1, line 38 to column 2, line 7, fig. 1 | 12 |
| A | JP 2021-185354 A (ENVISION AESC JAPAN LTD.) 09 December 2021 (2021-12-09) entire text, all drawings | 1-28 |
| A | WO 2021/186593 A1 (TOSHIBA KK) 23 September 2021 (2021-09-23) entire text, all drawings | 1-28 |
| A | WO 2019/240182 A1 (GS YUASA INT LTD) 19 December 2019 (2019-12-19) entire text, all drawings | 1-28 |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **31 October 2022** | **15 November 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
| --- |
| **PCT/JP2022/035710** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2019-132666 A (PRIMEARTH EV ENERGY CO LTD) 08 August 2019 (2019-08-08) entire text, all drawings | 1-28 |
| A | JP 2020-101399 A (TOYOTA MOTOR CORP) 02 July 2020 (2020-07-02) entire text, all drawings | 1-28 |
| P, A | WO 2022/080377 A1 (SHOWA DENKO KK) 21 April 2022 (2022-04-21) entire text, all drawings | 1-28 |

Form PCT/ISA/210 (second sheet) (January 2015)

## INTERNATIONAL SEARCH REPORT
### Information on patent family members

International application No.

**PCT/JP2022/035710**

| Patent document cited in search report | | | Publication date (day/month/year) | Patent family member(s) | | | Publication date (day/month/year) |
|---|---|---|---|---|---|---|---|
| JP | 2016-90346 | A | 23 May 2016 | (Family: none) | | | |
| WO | 2021/044132 | A1 | 11 March 2021 | GB fig. 1, column 1, lines 6-7, column 1, line 38 to column 2, line 7 | 2586654 | A | |
| JP | 2021-185354 | A | 09 December 2021 | WO entire text, all drawings | 2021/241115 | A1 | |
| WO | 2021/186593 | A1 | 23 September 2021 | US entire text, all drawings | 2021/0405120 | A1 | |
| WO | 2019/240182 | A1 | 19 December 2019 | US entire text, all drawings CN | 2021/0255251 112368904 | A1 A | |
| JP | 2019-132666 | A | 08 August 2019 | US entire text, all drawings | 2019/0235027 | A1 | |
| JP | 2020-101399 | A | 02 July 2020 | US entire text, all drawings CN | 2020/0200826 111352033 | A1 A | |
| WO | 2022/080377 | A1 | 21 April 2022 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022016957 A

- WO 2012095913 A